# EUROPEAN PATENT SPECIFICATION

(11) **EP 2 065 718 B1**
(45) Date of publication and mention of the grant of the patent: **18.04.2012**
(21) Application number: 07792821.6
(22) Date of filing: 15.08.2007
(51) Int. Cl.: G01R 31/36, B60L 11/18, H02J 7/14, H02J 7/02

(54) **DEGRADATION ASSESSMENT METHOD AND DEGRADATION ASSESSMENT SYSTEM FOR POWER STORAGE DEVICE MOUNTED ON A VEHICLE**
VERFAHREN UND SYSTEM ZUR BEURTEILUNG DER AKKUMULATORVERSCHLECHTERUNG IN EINEM FAHRZEUG
PROCÉDÉ ET SYSTÈME D'ÉVALUATION DE LA DÉGRADATION D'UN ACCUMULATEUR DANS UN VÉHICULE

(30) Priority: 30.08.2006 JP 2006233831; 04.01.2007 JP 2007000117
(43) Date of publication of application: 03.06.2009
(73) Proprietor: Toyota Jidosha Kabushiki Kaisha, Toyota-shi, Aichi 471-8571 (JP)
(72) Inventor: UCHIDA, Masatoshi, Toyota-shi Aichi 471-8571 (JP)
(74) Representative: Kuhnen & Wacker
(86) International application number: PCT/JP2007/066222
(87) International publication number: WO 2008/029613

(56) References cited:
- EP-A1- 1 261 064
- EP-A1- 1 536 539
- JP-A- 7 169 510
- JP-A- 2004 014 403
- JP-A- 2006 197 765
- US-A- 5 612 608
- US-A- 5 939 861
- US-A- 6 147 473
- US-A1- 2002 084 768
- US-A1- 2003 030 414

## Description

### Technical Field

The present invention relates to a technique for assessing a degradation state of a power storage device mounted on a vehicle.

### Background Art

The US 2003/0030414 A1 discloses a secondary battery deterioration calculating apparatus that calculates a battery output deterioration in conformance to the output ratio of the battery output ascertained as a secondary battery becomes depleted and an initial battery output, the extent of depletion of the secondary battery is calculated through an arithmetic operation by calculating an output ratio based upon the open circuit voltage of the secondary battery and the voltage manifesting while the secondary battery is charged with a constant current.

The US 2002/0084768 A1 discloses a method for controlling the charging state of a battery in order to diagnose the fail possibility and to compensate a charging state of a battery of an electric vehicle, by detecting an operating state of a battery while driving a vehicle that is equipped with a rechargeable battery.

The JP 07169510 discloses a remaining capacity detector for a NI-MH battery to accurately and easily detect a remaining capacity of the battery in real time by installing detecting means for the deterioration degree of the battery, output power and discharge amount, and correction means based on correlations and arithmetic means. A control unit finds a capacity decreased amount corresponding to a deterioration rate with a means which gets hold a deterioration degree from an internal resistance of the battery in a deteriorated capacity holding unit.

The EP 1 536 539 A1 discloses a rapid charging battery charging system for a rechargeable battery with a rapid charge capacity which can be recharged at a public place. The charging system comprises a charging equipment for the rapid charge battery, a measurement display unit which measures and displays charging condition and deterioration of the rapid charge battery, and a fee collection device which collects a charging fee.

The US 5,612,608 discloses an apparatus for displaying residual capacity of a battery for use in an electric vehicle. The apparatus includes a temperature indicator composed of a linear array of spaced light-emitting elements for displaying a temperature of the battery by way of light-emitted from a succession of those of the light-emitting elements which correspond to the temperature of the battery detected by a temperature detector, a fully charged capacitor indicator composed of a linear array of spaced light-emitting elements for displaying the fully charged capacity of the battery in association with the displayed temperature of the battery by a way of light emitted from one of the light-emitting elements which is in a position corresponding to the fully charged capacity obtained based on the temperature of the battery, and a residual capacity indicator composed of a linear area of spaced light-emitting elements for displaying the residual capacity of the battery in association with the fully charged capacity by way of light-emitted from a succession of those of the light-emitting elements which correspond to the residual capacity calculated by electronic control unit.

Japanese Patent Laying-Open No. 2004-014403 discloses a degradation determination device for a secondary battery. The degradation determination device includes load history estimation means for estimating a history of a load on a secondary battery based on the electric current flowing in the secondary battery, and degradation determination means for making a determination as to degradation of the secondary battery based on the terminal voltage of the secondary battery, when the current flowing in the secondary battery changes from a charge state or discharge state to approximately zero and when the load history estimated by the load history estimation means is within a range that can be regarded as a predetermined history.

The degradation determination device makes a determination as to degradation of the secondary battery only when the load history of the secondary battery is within a range that can be regarded as a predetermined history and therefore, the device can make an accurate determination as to degradation.

The degradation determination device disclosed in Japanese Patent Laying-Open No. 2004-014403 as described above makes a determination as to degradation of the secondary battery when the load history of the secondary battery is in a range that can be regarded as a predetermined history. In the case, however, where a determination is made as to degradation of a secondary battery mounted on an electrically-driven vehicle such as electric vehicle or hybrid vehicle, it appears less likely that the load history of the secondary battery is a specific history while the vehicle is traveling.

In particular, regarding a hybrid vehicle driven by the power from a motor as well as the power from an engine, the secondary battery discharges when the vehicle drive power is generated by a driving motor and when the engine is started using an electricity-generating motor, while the secondary battery is charged when the electrical energy is generated regeneratively by the electricity-generating motor using the engine power and when regenerative braking is performed by the driving motor. Thus, in the hybrid vehicle, the charging and discharging of the secondary battery are frequently performed according to the traveling state of the vehicle. Therefore, the degradation determination device disclosed in the above-referenced publication may not adequately assess the degradation state of the secondary battery.

Further, an appropriate indication to a user of a transition of the degradation state of such a secondary battery may serve as helpful information for the user to operate the vehicle, since the user can operate the vehicle while knowing the degradation state of the secondary battery and considering the degradation state.

### Disclosure of the Invention

The present invention has been made to solve the problems above, and an object of the invention is to provide a degradation assessment system and a vehicle capable of reliably assessing the degradation state of a power storage device mounted on the vehicle.

Another object of the present invention is to provide a degradation assessment system and a vehicle capable of appropriately indicating to a user the degradation state of a power storage device mounted on the vehicle.

Still another object of the present invention is to provide a degradation assessment method with which the degradation state of a power storage device mounted on a vehicle can be reliably assessed.

A further object of the present invention is to provide a degradation assessment method with which the degradation state of a power storage device mounted on a vehicle can be appropriately indicated to a user.

The present invention is defined by independent claims 1 and 7 and provides degradation assessment system as defined in claim 1 and a degradation assessment a method as defined in claim 7. The dependent claims define preferred embodiments of the invention.

According to the present invention, a degradation assessment system for a power storage device mounted on a vehicle is provided, and the degradation assessment system includes a vehicle and a degradation assessment device. The vehicle is configured such that electric power can be supplied and received between the power storage device and a power supply or electrical load located outside the vehicle. The degradation assessment device assesses a degradation state of the power storage device using data collected when electric power is supplied and received between the power storage device and the power supply or electrical load located outside the vehicle.

Preferably, the degradation assessment device assesses the degradation state of the power storage device using data collected when the power storage device is charged from the power supply located outside the vehicle.

Preferably, the vehicle includes an electric power conversion device, a connection device and a control device. The electric power conversion device is configured to be able to convert electric power between the power storage device and the power supply or electrical load located outside the vehicle. The connection device is configured to be able to electrically connect the electric power conversion device to the power supply or electrical load located outside the vehicle. The control device controls the electric power conversion device. The control device controls the electric power conversion device under a constant condition at least when the data is collected.

More preferably, when the data is collected, the control device controls the electric power conversion device such that the electric power supplied and received between the power storage device and the power supply or electrical load located outside the vehicle is larger than a specified value.

Preferably, the degradation assessment device assesses the degradation state of the power storage device when an environment of the vehicle or an environment surrounding the vehicle satisfies a specified condition.

Preferably, the degradation assessment device further includes a charge mode selection unit and a display unit. The charge mode selection unit can select one of a normal charge mode in which the power storage device is charged from the power supply located outside the vehicle at a first charge rate, and a quick charge mode in which the power storage device is charged from the power supply located outside the vehicle at a second charge rate higher than the first charge rate. The display unit can display a degradation state of the power storage device in a case where charging is performed in the normal charge mode, and a degradation state of the power storage device in a case where charging is performed in the quick charge mode.

More preferably, the display unit displays a state of charge of the power storage device and displays a transition of the degradation state of the power storage device in conjunction with a transition of the state of charge, while the power storage device is charged from the power supply located outside the vehicle.

According to the present invention, a vehicle capable of supplying and receiving electric power to and from a power supply or electrical load located outside the vehicle is provided, and the vehicle includes a power storage device, an electric power conversion device, a connection device, and a degradation assessment device. The electric power conversion device is configured to be able to convert electric power between the power storage device and the power supply or electrical load located outside the vehicle. The connection device is configured to be able to electrically connect the electric power conversion device to the power supply or electrical load located outside the vehicle. The degradation assessment device assesses a degradation state of the power storage device using data collected when electric power is supplied and received between the power storage device and the power supply or electrical load located outside the vehicle.

Preferably, the degradation assessment device assesses the degradation state of the power storage device using data collected when the power storage device is charged from the power supply located outside the vehicle.

Preferably, the vehicle further includes a control device controlling the electric power conversion device. The control device controls the electric power conversion device under a constant condition at least when the data is collected.

More preferably, when the data is collected, the control device controls the electric power conversion device such that the electric power supplied and received between the power storage device and the power supply or electrical load located outside the vehicle is larger than a specified value.

Preferably, the degradation assessment device assesses the degradation state of the power storage device when an environment of the vehicle or an environment surrounding the vehicle satisfies a specified condition.

Preferably, the vehicle further includes a charge mode selection unit and a display device. The charge mode selection unit can select one of a normal charge mode in which the power storage device is charged from the power supply located outside the vehicle at a first charge rate, and a quick charge mode in which the power storage device is charged from the power supply located outside the vehicle at a second charge rate higher than the first charge rate. The display device is capable of displaying a degradation state of the power storage device in a case where charging is performed in the normal charge mode, and a degradation state of the power storage device in a case where charging is performed in the quick charge mode.

More preferably, the display device displays a state of charge of the power storage device and displays a transition of the degradation state of the power storage device in conjunction with a transition of the state of charge, while the power storage device is charged from the power supply located outside the vehicle.

According to the present invention, a degradation assessment method for a power storage device mounted on a vehicle is provided. The vehicle is configured such that electric power can be supplied and received between the power storage device and a power supply or electrical load located outside the vehicle. The degradation assessment method includes a first step of collecting data for assessing a degradation state of the power storage device when electric power is supplied and received between the power storage device and the power supply or electrical load located outside the vehicle, and a second step of assessing the degradation state of the power storage device using the collected data.

Preferably, the data is collected in the first step when the power storage device is charged from the power supply located outside the vehicle.

Preferably, the vehicle includes an electric power conversion device and a connection device. The electric power conversion device is configured to be able to convert electric power between the power storage device and the power supply or electrical load located outside the vehicle. The connection device is configured to be able to electrically connect the electric power conversion device to the power supply or electrical load located outside the vehicle. The degradation assessment method further includes a third step of controlling the electric power conversion device under a constant condition at least when the data is collected.

More preferably, when the data is collected, the electric power conversion device is controlled in the third step such that the electric power supplied and received between the power storage device and the power supply or electrical load located outside the vehicle is larger than a specified value.

Preferably, the degradation assessment method further includes a fourth step of determining whether or not an environment of the vehicle or an environment surrounding the vehicle satisfies a specified condition. When it is determined that the environment satisfies the specified condition, the degradation state of the power storage device is assessed in the second step.

Preferably, the degradation assessment method further includes a fifth step and a sixth step. The fifth step selects one of a normal charge mode in which the power storage device is charged from the power supply located outside the vehicle at a first charge rate, and a quick charge mode in which the power storage device is charged from the power supply located outside the vehicle at a second charge rate higher than the first charge rate. The sixth step displays at least one of a degradation state of the power storage device in a case where charging is performed in the normal charge mode, and a degradation state of the power storage device in a case where charging is performed in the quick charge mode.

More preferably, in the sixth step, a state of charge of the power storage device is displayed and a transition of the degradation state of the power storage device is displayed in conjunction with a transition of the state of charge, while the power storage device is charged from the power supply located outside the vehicle.

Further, according to the present invention, a computer-readable recording medium has a program recorded for a computer to execute any degradation assessment method as described above.

The present invention provides the vehicle that is configured such that electric power can be supplied and received between the power storage device mounted on the vehicle and the power supply or electrical load located outside the vehicle. The degradation assessment device assesses the degradation state of the power storage device using data collected when electric power is supplied and received between the power storage device and the power supply or electrical load located outside the vehicle. Thus, the data collected under stable conditions is used to assess the degradation state of the power storage device.

The present invention can thus reliably assess the degradation state of the power storage device mounted on the vehicle. Further, the present invention can accurately assess the degradation state of the power storage device.

Further, the present invention can select one of the normal charge mode and the quick charge mode, and can indicate a degradation state of the power storage device in the case where charging is performed in the normal charge mode and a degradation state of the power storage device in the case where charging is performed in the quick charge mode.

The present invention can thus appropriately indicate to a user the degradation state of the power storage device mounted on the vehicle. Accordingly, the user can select a charge mode for charging the power storage device from a power supply outside the vehicle, in consideration of the degradation state of the secondary battery.

### Brief Description of the Drawings

Fig. 1 is an overall view of a degradation assessment system according to a first embodiment of the present invention.
Fig. 2 is a functional block diagram of a degradation assessment device shown in Fig. 1.
Fig. 3 is a diagram showing an example of degradation assessment indicated on a display unit shown in Fig. 2.
Fig. 4 is a flowchart illustrating a control structure of the degradation assessment device shown in Fig. 1.
Fig. 5 is a schematic configuration diagram of a vehicle shown in Fig. 1.
Fig. 6 is a functional block diagram of a power output device shown in Fig. 5.
Fig. 7 is a zero-phase equivalent circuit diagram of inverters and motor generators shown in Fig. 6.
Fig. 8 is a diagram showing degradation assessment indicated on a display unit according to a first modification of the first embodiment.
Fig. 9 is a diagram showing a charge rate of a power storage device according to a second modification of the first embodiment.
Fig. 10 is a diagram showing degradation assessment indicated on a display unit according to the second modification of the first embodiment.
Fig. 11 is a flowchart illustrating a control structure of a degradation assessment device according to the second modification of the first embodiment.
Fig. 12 is a flowchart illustrating a control structure of a degradation assessment device according to a third modification of the first embodiment.
Fig. 13 is a functional block diagram of a degradation assessment device according to a fourth modification of the first embodiment.
Fig. 14 is a diagram showing the time and the distance for which the vehicle can travel.
Fig. 15 is a schematic configuration diagram of a vehicle according to a second embodiment.
Fig. 16 is a schematic configuration diagram of a vehicle according to a third embodiment.
Fig. 17 is a functional block diagram of a vehicle ECU shown in Fig. 16.
Fig. 18 is a functional block diagram of a degradation assessment device according to a fourth embodiment.
Fig. 19 is a flowchart illustrating a control structure of the degradation assessment device according to the fourth embodiment.
Fig. 20 is a diagram showing one example of the state of display when charging is performed in a quick charge mode.
Fig. 21 is a diagram showing an example of the state of display while charging is performed.
Fig. 22 is a schematic configuration diagram of a vehicle according to a fifth embodiment.
Fig. 23 is a functional block diagram of a vehicle ECU shown in Fig. 22.

### Best Modes for Carrying Out the Invention

Embodiments of the present invention will be described in detail hereinafter with reference to the drawings. In the drawings, like or corresponding components are denoted by like reference characters, and a description thereof will not be repeated.

### [First Embodiment]

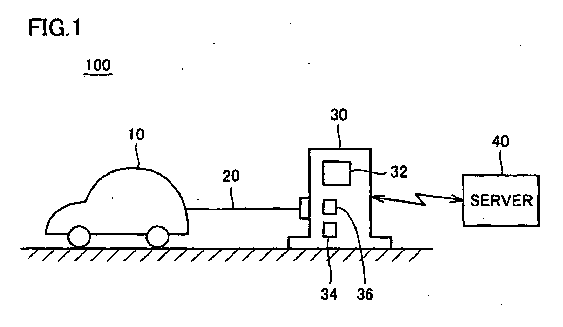

Fig. 1 is an overall view of a degradation assessment system according to a first embodiment of the present invention. Referring to Fig. 1, degradation assessment system 100 includes a vehicle 10, a charge station 30 and a server 40.

Vehicle 10 is an electrically-driven vehicle mounted with a power storage device and a motor each serving as a source for supplying power, and is configured for example as an electric vehicle or hybrid vehicle. The following description of the first embodiment is applied particularly to a hybrid vehicle in which the power storage device is charged and discharged frequently. Vehicle 10 can be connected by a connection cable 20 to charge station 30, and the power storage device can be charged with electric power supplied from charge station 30 as described hereinlater.

Connection cable 20 is an electric power line for supplying a charging electric power from charge station 30 to vehicle 10. Further, connection cable 20 is used as a data communication medium between charge station 30 and vehicle 10. Charge station 30 is a facility for charging the power storage device of vehicle 10 connected by connection cable 20, and supplies electric power from a commercial electric power system (not shown) to vehicle 10 via connection cable 20.

Charge station 30 includes a degradation assessment device 32, a current sensor 34 and a voltage sensor 36. Current sensor 34 detects current Is that is supplied from charge station 30 to vehicle 10. Voltage sensor 36 detects voltage Vs that is output from charge station 30 to vehicle 10. While vehicle 10 is charged from charge station 30, degradation assessment device 32 assesses the degradation state of the power storage device of vehicle 10 using various data collected from current sensor 34, voltage sensor 36 and vehicle 10.

Server 40 has assessment data for each type of vehicles for assessing the degradation state of a power storage device of a vehicle that can be connected to charge station 30, and outputs to degradation assessment device 32 the assessment data associated with vehicle 10 connected to charge station 30, in response to a request from degradation assessment device 32. Here, server 40 may not be provided and charge station 30 may have the assessment data.

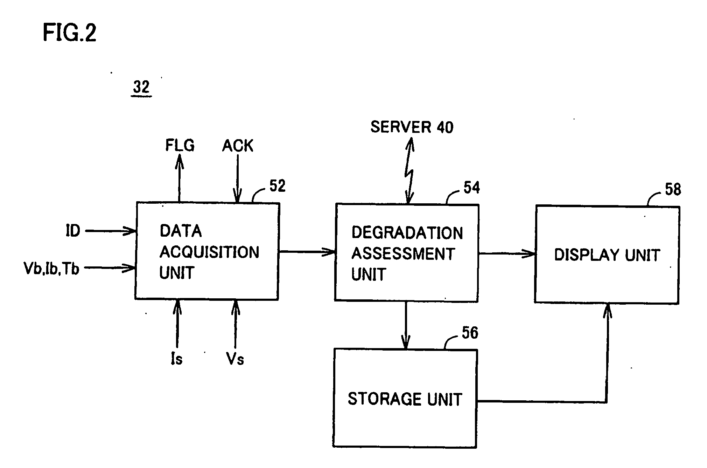

Fig. 2 is a functional block diagram of degradation assessment device 32 shown in Fig. 1. Referring to Fig. 2, degradation assessment device 32 includes a data acquisition unit 52, a degradation assessment unit 54, a storage unit 56, and a display unit 58.

Data acquisition unit 52 acquires current Is and voltage Vs respectively from current sensor 34 and voltage sensor 36, and determines whether or not vehicle 10 is charged from charge station 30, based on the state of connection of connection cable 20 and the acquired current Is and voltage Vs. When vehicle 10 is charged, data acquisition unit 52 activates flag FLG that is output via connection cable 20 to vehicle 10 for a preset period (for example a specified period from the time when charging is started to the time after a specified time from the start of charging). Here, flag FLG is a signal for giving an instruction to transmit to degradation assessment device 32 various data collected for assessing the degradation state of the power storage device mounted on vehicle 10. The collected data includes for example voltage Vb, charging current Ib and temperature Tb of the power storage device mounted on vehicle 10. Data acquisition unit 52 receives from vehicle 10 response signal ACK to the activation of flag FLG, and then acquires data transmitted via connection cable 20 from vehicle 10.

Degradation assessment unit 54 uses the data acquired by data acquisition unit 52 to calculate degradation data with which the degradation state of the power storage device of vehicle 10 can be assessed. Specifically, degradation assessment unit 54 uses the collected data that is acquired by data acquisition unit 52 to calculate the charging efficiency. Here, the charging efficiency refers to the ratio of the amount of electric power actually stored in the power storage device of vehicle 10 to the amount of electric power supplied from charge station 30 to vehicle 10. As the power storage device degrades, the charging efficiency decreases.

Further, based on identification code ID of vehicle 10, degradation assessment unit 54 acquires from server 40 the assessment data for assessing the degradation state of vehicle 10. Specifically, the assessment data includes a first charging efficiency level value indicating that the power storage device degrades to a considerable degree, and a second charging efficiency level value indicating that the power storage device has to be overhauled. Degradation assessment unit 54 associates the calculated degradation data and the assessment data acquired from server 40 with identification code ID of vehicle 10 and the day and time when the data is collected, and outputs the data to storage unit 56.

Storage unit 56 is configured with a nonvolatile memory and, each time vehicle 10 is charged from charge station 30, the storage unit stores the degradation data and the assessment data that are received from degradation assessment unit 54 in association with identification code ID and the data collection date and time.

Based on identification code ID of vehicle 10, display unit 58 reads from storage unit 56 the data (not only the data concerning the latest charging but also the data concerning charging in the past) associated with vehicle 10, and indicates the read data to a user. Further, based on the latest charging data and the past charging data, display unit 58 predicts a future degradation state and indicates the results of prediction. For example, the future degradation state can be predicted by extrapolation of a regression curve calculated using the latest charging data and the past charging data.

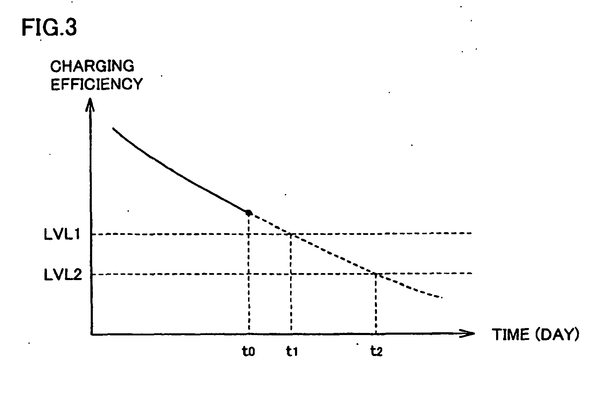

Fig. 3 is a diagram showing an example of degradation assessment indicated on display unit 58 shown in Fig. 2. Referring to Fig. 3, the vertical axis represents the charging efficiency when vehicle 10 is charged from charge station 30, and the horizontal axis represents the time (on the day basis). The solid line portion shows a transition of the charging efficiency to the present, and the dotted line portion shows a future transition of the charging efficiency that is predicted based on the transition of the charging efficiency up to the present. Here, time t0 corresponds to the present.

First level LVL1 and second level LVL2 correspond to the assessment data acquired from server 40. First level LVL1 is a level indicating that the power storage device degrades to a considerable degree, and second level LVL2 represents a level indicating that the power storage device has to be overhauled. Thus, the user can recognize the degradation state of the power storage device.

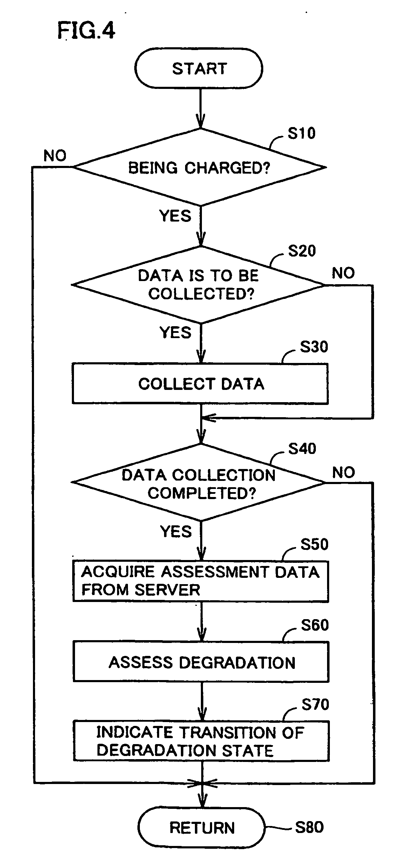

Fig. 4 is a flowchart illustrating a control structure of degradation assessment device 32 shown in Fig. 1. The process of the flowchart is called from a main routine and executed at regular time intervals or each time a predetermined condition is satisfied.

Referring to Figs. 4 and 1, degradation assessment device 32 determines whether or not vehicle 10 is charged from charge station 30, based on the state of connection of connection cable 20 and the detected values of current sensor 34 and voltage sensor 36 (step S10). When degradation assessment device 32 determines that the vehicle is not charged (NO in step S10), the process advances to step S80.

In contrast, when it is determined that the vehicle is charged in step S10 (YES in step S10), degradation assessment device 32 determines whether or not data is to be collected for assessing the degradation state of the power storage device (step S20). The data is collected in a preset period (for example, a specified period from the time when charging is started to the time after a specified time from the time when charging is started) as described above.

When degradation assessment device 32 determines that the data is to be collected (YES in step S20), the assessment device activates flag FLG. When response signal ACK to the flag is activated, the assessment device acquires voltage Vb, charging current Ib and temperature Tb of the power storage device mounted on vehicle 10, from vehicle 10 via connection cable 20, and acquires current Is and voltage Vs from current sensor 34 and voltage sensor 36 respectively (step S30). Further, degradation assessment device 32 acquires from vehicle 10 identification code ID of vehicle 10 connected to charge station 30. In contrast, when degradation assessment device 32 determines that the data is not to be collected in step S20 (NO in step S20), the process advances to step S40.

Then, degradation assessment device 32 determines whether or not the collection of the data is completed (step S40). When degradation assessment device 32 determines that the data collection is not completed (NO in step S40), the process advances to step S80.

In contrast, when it is determined that the data collection is completed in step S40 (YES in step S40), degradation assessment device 32 acquires the assessment data associated with vehicle 10 from server 40 (step S50). When the assessment data is acquired, degradation assessment device 32 uses the data collected in step S30 to assess the degradation state of the power storage device of vehicle 10 (step S60). Specifically, degradation assessment device 32 uses the data collected in step S30 to calculate degradation data (charging efficiency in the first embodiment) with which the degradation state of the power storage device can be assessed.

Degradation assessment device 32 then indicates, together with the calculated degradation data for the latest charging, the degradation data calculated for the past charging, predicted data for future degradation, and the assessment data acquired from server 40, so as to indicate to the user a transition of the degradation state of the power storage device (step S70).

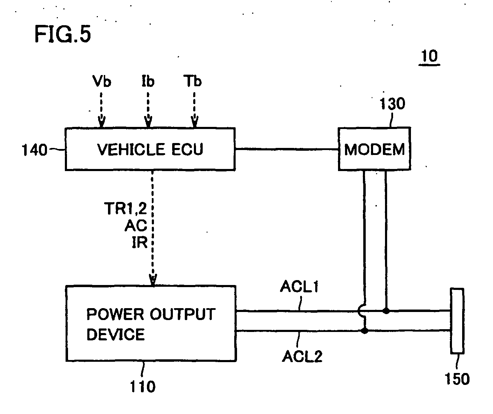

Fig. 5 is a schematic configuration diagram of vehicle 10 shown in Fig. 1. Referring to Fig. 5, vehicle 10 includes a power output device 110, a modem 130, a vehicle ECU (Electronic Control Unit) 140, electric power lines ACL1, ACL2, and a connector 150. Electric power lines ACL1, ACL2 here correspond to connection cable 20 shown in Fig. 1.

Power output device 110 outputs a drive power for vehicle 10. When signal AC from vehicle ECU 140 is activated, power output device 110 converts a commercial electric power (charging electric power) supplied from charge station 30 (not shown) connected to connector 150 to electric power lines ACL1, ACL2 into a DC electric power to charge the power storage device (not shown). When the power storage device is charged, power output device 110 charges the power storage device at a constant charge rate based on electric current command IR from vehicle ECU 140. The configuration of power output device 110 will be descried hereinlater. Modem 130 is a communication device connected to electric power lines ACL1, ACL2 for communicating data via electric power lines ACL1, ACL2 to and from charge station 30 connected to connector 150.

When connector 150 is not connected to charge station 30 and the vehicle can travel, vehicle ECU 140 inactivates signal AC that is output to power output device 110, generates torque command values TR1, TR2 for motor generators included in power output device 110, and outputs the generated torque command values TR1, TR2 to power output device 110.

Further, when the power storage device in power output device 110 is charged from charge station 30, vehicle ECU 140 activates signal AC and generates current command IR that is a target value of the charging current from charge station 30 to output the command to power output device 110.

Furthermore, when flag FLG from charge station 30 received by modem 130 is activated while the power storage device is charged, vehicle ECU 140 outputs response signal ACK to charge station 30 via modem 130. Then, vehicle ECU 140 collects voltage Vb, charging current Ib and temperature Tb of the power storage device in power output device 110 to transmit the data to charge station 30 via modem 130. Vehicle ECU 140 also transmits to charge station 30 identification code ID of this vehicle 10.

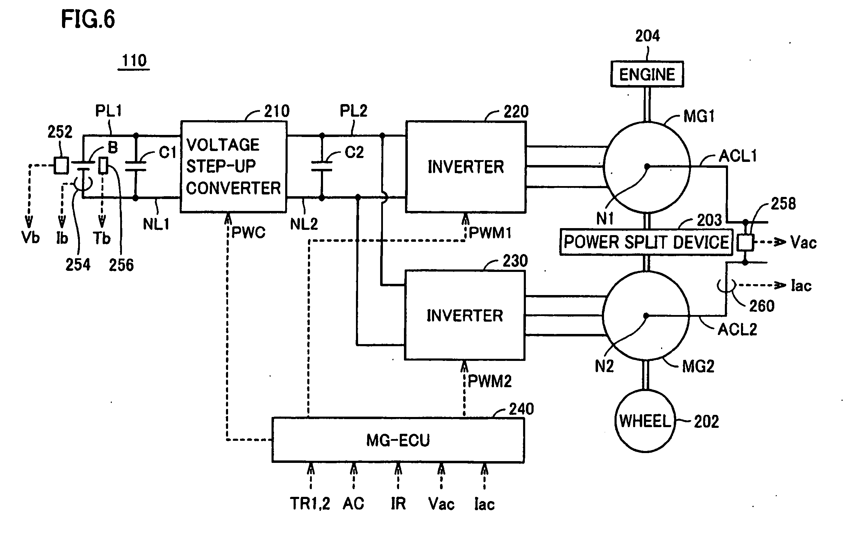

Fig. 6 is a functional block diagram of power output device 110 shown in Fig. 5. Referring to Fig. 6, power output device 110 includes an engine 204, motor generators MG1, MG2, a power split device 203, and a wheel 202. Power output device 110 also includes a power storage device B, a voltage step-up converter 210, inverters 220, 230, an MG-ECU 240, capacitors C1, C2, positive lines PL1, PL2, and negative lines NL1, NL2. Power output device 110 further includes voltage sensors 252, 258, current sensors 254, 260 and a temperature sensor 256.

Power split device 203 is coupled to engine 204 and motor generators MG1, MG2 to split the power between the engine and motor generators. For example, a planetary gear set having three rotational shafts of a sun gear, a planetary carrier and a ring gear may be used as power split device 203.

Motor generator MG1 is incorporated in power output device 110 to operate as an electric generator driven by engine 204 and also operate as an electric motor that can start engine 204. Motor generator MG2 is incorporated in power output device 110 to operate as an electric motor driving wheel 202 that is a drive wheel.

Motor generators MG1, MG2 each include Y-connected three-phase coils (not shown) as stator coils. Electric power line ACL1 is connected to a neutral point N1 of the three-phase coils of motor generator MG1, and electric power line ACL2 is connected to a neutral point N2 of the three-phase coils of motor generator MG2.

Power storage device B is a chargeable DC power source and configured for example with a secondary battery such as nickel-metal-hydride or lithium-ion battery. Power storage device B outputs a DC power to voltage step-up converter 210. Further, power storage device B is charged with the electric power that is output from voltage step-up converter 210.

Capacitor C1 smoothes a voltage variation between positive line PL1 and negative line NL1. Based on signal PWC from MG-ECU 240, voltage step-up converter 210 steps up the DC voltage supplied from power storage device B, and outputs the stepped up voltage to positive line PL2. Further, based on signal PWC, voltage step-up converter 210 steps down the DC voltage supplied from inverters 220, 230 via positive line PL2 to a voltage level of power storage device B so as to charge power storage device B. Voltage step-up converter 210 is configured for example with a voltage step-up-and-down-type chopper circuit.

Capacitor C2 smoothes a voltage variation between positive line PL2 and negative line NL2. Based on signal PWM1 from MG-ECU 240, inverter 220 converts the DC voltage supplied from positive line PL2 into a three-phase AC voltage, and outputs the resultant three-phase AC voltage to motor generator MG1. Further, based on signal PWM1, inverter 220 converts the electric power generated by motor generator MG1 from the output of engine 204 into a DC voltage, and outputs the resultant DC voltage to positive line PL2.

Based on signal PWM2 from MG-ECU 240, inverter 230 converts the DC voltage supplied from positive line PL2 into a three-phase AC voltage, and outputs the resultant three-phase AC voltage to motor generator MG2. Thus, motor generator MG2 is driven to generate a specified torque. Further, when regenerative braking of the vehicle is performed, inverter 230 receives a rotational force from wheel 202 to convert the three-phase AC voltage generated by motor generator MG2 into a DC voltage based on signal PWM2, and output the resultant DC voltage to positive line PL2.

Further, when power storage device B is charged with the commercial electric power supplied from charge station 30 (not shown), inverters 220, 230 convert the commercial electric power that is supplied from charge station 30 to neutral points N1, N2 via electric power lines ACL1, ACL2 into a DC power based on signals PWM1, PWM2, and output the resultant DC power to positive line PL2.

Motor generators MG1, MG2 are each a three-phase AC electric motor, and configured for example with a three-phase AC synchronous electric motor. Motor generator MG1 generates a three-phase AC voltage using the output of engine 204, and outputs the generated three-phase AC voltage to inverter 220. Further, motor generator MG1 generates drive power using the three-phase AC voltage supplied from inverter 220 to start engine 204. Motor generator MG2 generates a drive torque for the vehicle using the three-phase AC voltage supplied from inverter 230. Further, when regenerative braking of the vehicle is performed, motor generator MG2 generates a three-phase AC voltage to output the voltage to inverter 230.

Voltage sensor 252 detects voltage Vb of power storage device B, and outputs the detected value to vehicle ECU 140 (not shown). Current sensor 254 detects charging current Ib for power storage device B, and outputs the detected value to vehicle ECU 140. Temperature sensor 256 detects temperature Tb of power storage device B, and outputs the detected value to vehicle ECU 140. Voltage sensor 258 detects voltage Vac between electric power lines ACL1, ACL2, and outputs the detected value to MG-ECU 240. Current sensor 260 detects current Iac flowing through electric power line ACL2, and outputs the detected value to MG-ECU 240.

When signal AC from vehicle ECU 140 is inactivated, MG-ECU 240 generates signal PWC for driving voltage step-up converter 210 and signals PWM1, PWM2 for driving inverters 220, 230 respectively, based on torque command values TR1, TR2 from vehicle ECU 140, and outputs the generated signals PWC, PWM1, PWM2 to voltage step-up converter 210 and inverters 220, 230 respectively.

In contrast, when signal AC from vehicle ECU 140 is activated, MG-ECU 240 generates signals PWM1, PWM2, PWC for controlling inverters 220, 230 and voltage step-up converter 210 so that the commercial electric power supplied from charge station 30 to neutral points N1, N2 via electric power lines ACL1, ACL2 is converted into DC electric power to charge power storage device B.

Here, when power storage device B is charged from charge station 30, MG-ECU 240 controls inverters 220, 230 so that the current supplied from charge station 30 corresponds to current command IR from vehicle ECU 140, based on voltage Vac from voltage sensor 258 and current Iac from current sensor 260.

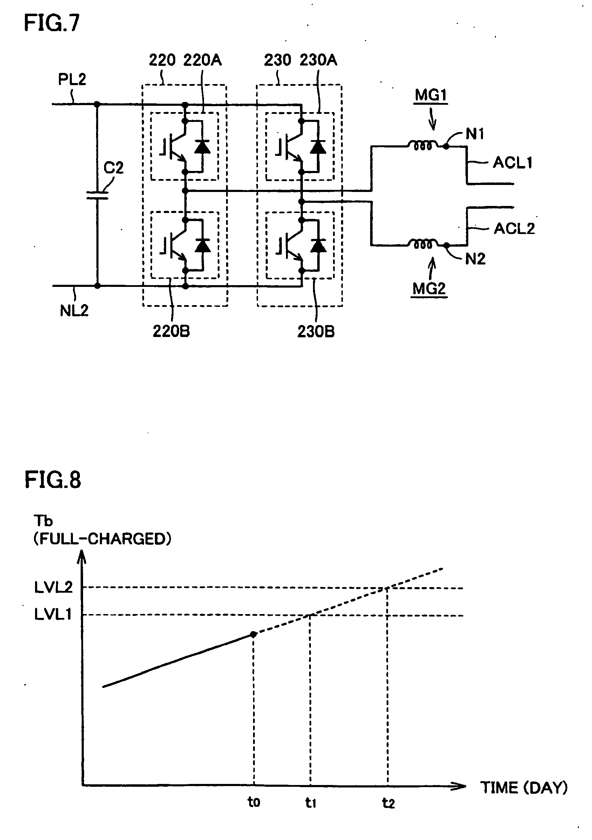

Fig. 7 is a zero-phase equivalent circuit of inverters 220, 230 and motor generators MG1, MG2. For each of inverters 220, 230 that are three-phase inverters, there are eight combination patterns of ON and OFF of six transistors. Regarding two of the eight switching patterns, the phase-to-phase voltage is zero and this voltage state is referred to as zero voltage vector. In the case of the zero voltage vector, the three transistors of the upper arm can be regarded as being in the same switching state (all transistors are ON or OFF), and the three transistors of the lower arm can also be regarded as being the same switching state. Therefore, in Fig. 7, the three transistors in the upper arm of inverter 220 are collectively shown as an upper arm 220A, while the three transistors in the lower arm of inverter 220 are collectively shown as a lower arm 220B. Similarly, the three transistors in the upper arm of inverter 230 are collectively shown as an upper arm 230A, while the three transistors in the lower arm of inverter 230 are collectively shown as a lower arm 230B.

As shown in Fig. 7, this zero-phase equivalent circuit can be regarded as a single-phase PWM converter having its input receiving single-phase AC commercial electric power that is supplied to neutral points N1, N2 via electric power lines ACL1, ACL2. Accordingly, the AC commercial electric power that is input from electric power lines ACL1, ACL2 can be converted into DC electric power to output the DC electric power to positive line PL2, by changing the zero voltage vector of inverters 220, 230 each and controlling switching of inverters 220, 230 so that each of the inverters operates as each phase arm of the single-phase PWM converter.

Referring again to Fig. 5, in this vehicle 10, power storage device B in power output device 110 can be charged from charge station 30 connected to connector 150. The charging current from charge station 30 can be controlled arbitrarily based on current command IR. While flag FLG supplied from charge station 30 via modem 130 is activated, vehicle ECU 140 generates current command IR so that charging is performed at least at a constant charge rate.

While flag FLG is activated, vehicle ECU 140 collects data about voltage Vb, charging current Ib and temperature Tb of power storage device B, and outputs the collected data to charge station 30 via modem 130.

Specifically, when power storage device B is charged from charge station 30, the environment (such as temperature) of power storage device B is stable as compared with that when vehicle 10 is traveling and the charge conditions (such as charge rate) of power storage device B can be set arbitrarily. Therefore, in the first embodiment, the data about power storage device B is collected when charging is performed and the state of power storage device B is stable, and the degradation of power storage device B is assessed based on the collected data.

According to the first embodiment as seen from above, degradation assessment device 32 uses the data collected when power storage device B is charged from charge station 30 to assess the degradation of power storage device B. Therefore, the degradation of power storage device B is assessed using the data collected under the stable conditions. Thus, the first embodiment can surely assess the degradation of power storage device B mounted on vehicle 10. Further, the degradation of power storage device B can be assessed accurately.

Further, according to the first embodiment, charge station 30 assesses the degradation of power storage device B. Therefore, the assessment data about various types of vehicles that can be connected to charge station 30 can be managed together. Further the cost for the vehicle can be prevented from increasing.

### [First Modification of the First Embodiment]

In the first embodiment, the charging efficiency is used as the degradation data with which the degradation state of power storage device B can be assessed. Another data may be used instead of the charging efficiency. For example, the secondary battery generally has the nature that the secondary battery has an increased temperature when the battery is fully charged, and the degree of temperature increase in the full-charge state is larger as the degree of degradation of the secondary battery is larger. Therefore, the data about temperature Tb when power storage device B is fully charged can be collected to assess the degradation state of power storage device B using the collected data about temperature Tb.

Fig. 8 is a diagram showing degradation assessment indicated on the display unit according to a first modification of the first embodiment. Referring to Fig. 8, the vertical axis represents temperature Tb when power storage device B is fully charged, and the horizontal axis represents the time (on the day basis). The solid line portion shows a transition of temperature Tb in the full-charge state to the present, and the dotted line portion shows a future transition of temperature Tb in the full-charge state that is predicted based on the transition of temperature Tb in the full-charge state to the present. Here, time t0 corresponds to the present.

First level LVL1 and second level LVL2 correspond to the assessment data acquired from server 40. First level LVL1 is a temperature indicating that power storage device B degrades to a considerable degree, and second level LVL2 represents a level indicating that power storage device B has to be overhauled. Thus, the user can recognize the degradation state of power storage device B.

### [Second Modification of the First Embodiment]

While power storage device B is charged from charge station 30, a desired charge condition (charge rate) can be set, which is different from the state where vehicle 10 is traveling. Here, voltage Vb of power storage device B increases as power storage device B is charged further. As the degree of degradation of power storage device B increases, however, the resistance loss increases because the internal resistance increases and accordingly the rate of increase of voltage Vb decreases. Since the resistance loss is proportional to the square of the charging current, the rate of increase of voltage Vb decreases more conspicuously as the charge rate is larger. Accordingly, the degradation state of power storage device B can be assessed based on the rate of increase of voltage Vb while power storage device B is charged from charge station 30.

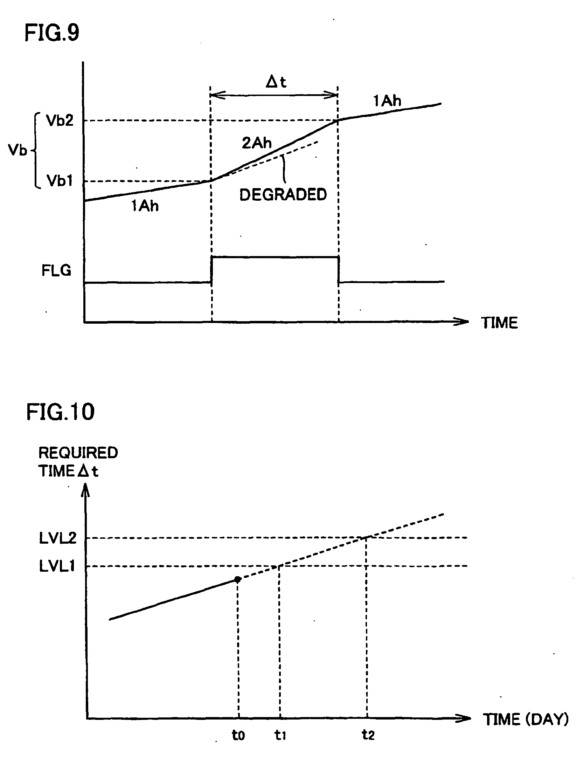

Fig. 9 is a diagram showing the charge rate of power storage device B according to a second modification of the first embodiment. Referring to Fig. 9, vehicle 10 is usually charged at a charge rate of 1 Ah (1 ampere per hour) for example. When voltage Vb of power storage device B reaches Vb1, charge station 30 activates flag FLG. Accordingly, the charge rate is increased to a constant value (2 Ah for example) higher than the specified value. When voltage Vb reaches Vb2 (> Vb1), charge station 30 inactivates flag FLG and changes the charge rate back to 1 Ah.

Charge station 30 measures the time for which flag FLG is activated (namely the period for which response signal ACK to flag FLG is activated), namely measures time Δt taken by the voltage of power storage device B to increase from Vb to Vb2, and assesses the degradation state of power storage device B based on time Δt.

Fig. 10 is a diagram showing degradation assessment indicated on the display unit according to a second modification of the first embodiment. Referring to Fig. 10, the vertical axis represents time Δt taken by the voltage of power storage device B to increase from Vb1 to Vb2, and the horizontal axis represents the time (on the day basis). The solid line portion shows a transition of required time Δt for the past charging and the latest charging, and the dotted line portion shows a future transition of required time Δt that is predicted based on the transition of required time Δt to the present. Here, time t0 corresponds to the present.

First level LVL1 and second level LVL2 correspond to the assessment data acquired from server 40. First level LVL1 represents a level indicating that power storage device B degrades to a considerable degree, and second level LVL2 represents a level indicating that power storage device B has to be overhauled. Thus, the user can recognize the degradation state of power storage device B.

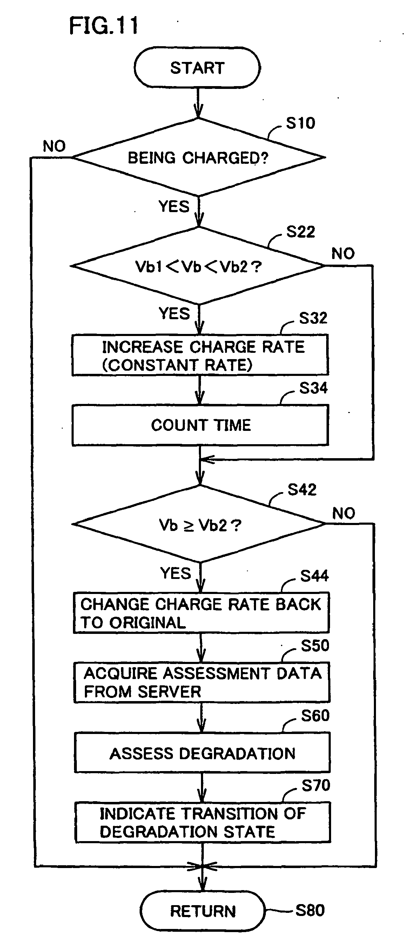

Fig. 11 is a flowchart illustrating a control structure of the degradation assessment device according to the second modification of the first embodiment. The process of the flowchart is also called from a main routine and executed at regular time intervals or each time a predetermined condition is satisfied.

Referring to Fig. 11, the flowchart differs from the flowchart shown in Fig. 4 in that the former includes steps S22, S32, S34, S42, S44 instead of steps S20, S30, S40. Specifically, when it is determined in step S10 that power storage device B is being charged (YES in step S10), degradation assessment device 32 determines whether or not voltage Vb of power storage device B is higher than Vb1 and lower than Vb2 (step S22). When degradation assessment device 32 determines that voltage Vb is equal to or lower than Vb1 or equal to or higher than Vb2 (NO in step S22), the process advances to step S42 described hereinlater.

In contrast, when it is determined in step S22 that voltage Vb is higher than Vb1 and lower than Vb2 (YES in step S22), degradation assessment device 32 activates flag FLG that is output to vehicle 10. Then, the charge rate of vehicle 10 when power storage device B is charged from charge station 30 is increased to a constant value higher than the specified value (step S32). Degradation assessment device 32 then measures the time while flag FLG is activated (namely the time for which the charge rate increases) (step S34).

Then, degradation assessment device 32 determines whether or not voltage Vb changes to Vb2 or higher (step S42). When degradation assessment device 32 determines that voltage Vb is lower than Vb2 (NO in step S42), the process advances to step S80. In contrast, when it is determined in step S42 that voltage Vb changes to Vb2 or higher (YES in step S42), degradation assessment device 32 changes the charge rate when power storage device B is charged from charge station 30, back to a usual rate (step S44). Then, the process of degradation assessment device 32 advances to step S50.

According to the second modification of the first embodiment as seen from above, a constant charge condition (charge rate) is set while power storage device B is charged from charge station 30 and, based on the data collected at this time, the degradation state of power storage device B is assessed. Thus, the second modification can more accurately assess the degradation of power storage device B. Since the charge rate is increased while the data is collected, the degradation state of power storage device B can be surely recognized.

### [Third Modification of the First Embodiment]

In order to more accurately assess the degradation of power storage device B, it is desirable that the data is collected under the same charge condition and that the data is also collected in the same environment (such as temperature). Here, while charging is performed from charge station 30, vehicle 10 is stopped and the power storage device can be charged in a garage. Therefore, it is supposed that the surrounding environment of vehicle 10 is stable as compared with the environment while vehicle 10 is traveling. Accordingly, a third modification of the first embodiment collects the data when the environment when charging is performed satisfies a specified condition and assesses the degradation state of power storage device B based on the collected data.

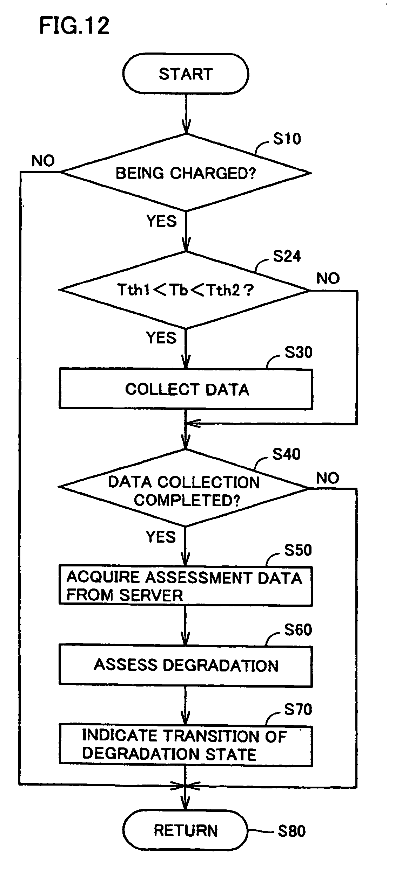

Fig. 12 is a flowchart illustrating a control structure of the degradation assessment device according to the third modification of the first embodiment. The process of the flowchart is also called from a main routine and executed at regular time intervals or each time when a predetermined condition is satisfied.

Referring to Fig. 12, the flowchart differs from the flowchart shown in Fig. 4 in that the former includes step S24 instead of step S20. Specifically, when it is determined in step S10 that power storage device B is being charged, degradation assessment device 32 determines whether temperature Tb of power storage device B is higher than threshold value Tth1 and lower than threshold value Tth2 (< Tth1) (step S24).

When degradation assessment device 32 determines that temperature Tb is equal to or lower than threshold value Tth1 or equal to or higher than threshold value Tth2 (NO in step S24), the process advances to step S40. In contrast, when degradation assessment device 32 determines in step S24 that temperature Tb is higher than threshold value Tth1 and lower than threshold value Tth2 (YES in step S24), the process of degradation assessment device 32 advances to step S30 where voltage Vb, charging current Ib and temperature Tb of the power storage device mounted on vehicle 10 are acquired from vehicle 10 via connection cable 20.

According to the description above, the data for assessing the degradation state of power storage device B is collected when temperature Tb of power storage device B falls in a specified range. The data, however, may be collected when the vehicle or the surrounding environment (such as the temperature around the vehicle for example) satisfies a specified condition.

According to the third modification of the first embodiment as seen from above, the data for assessing the degradation state of power storage device B is collected when the environment while charging is performed satisfies a specified condition. Thus, the third modification can more accurately assess the degradation state of power storage device B.

### [Fourth Modification of the First Embodiment]

According to the description above, the result of assessment of the degradation state of power storage device B is indicated at charge station 30. According to a fourth modification of the first embodiment, however, the result of assessment is transmitted from charge station 30 to vehicle 10 and displayed at vehicle 10.

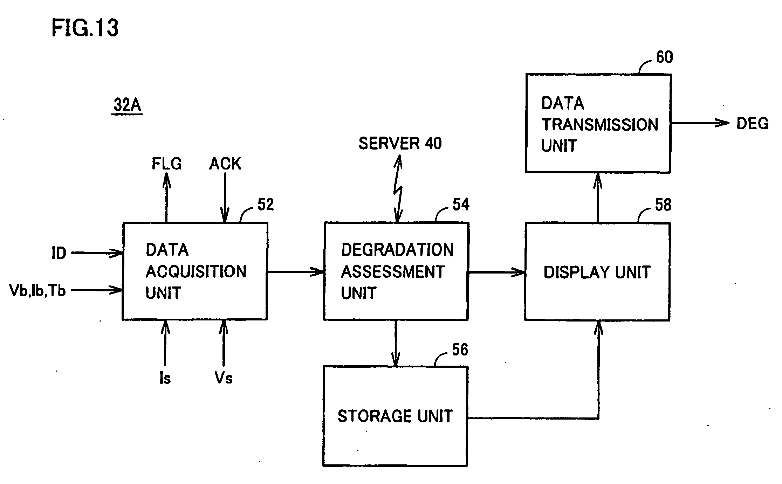

Fig. 13 is a functional block diagram of a degradation assessment device according to the fourth modification of the first embodiment. Referring to Fig. 13, this degradation assessment device 32A includes a data transmission unit 60 in addition to the components of degradation assessment device 32 in the first embodiment shown in Fig. 2. Data transmission unit 60 acquires from display unit 58 the data indicated on display unit 58, and converts the acquired data according to a conversion map set in advance.

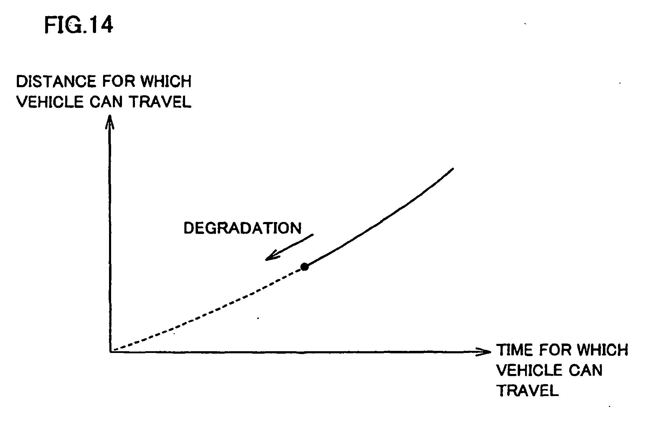

For example, data transmission unit 60 uses a prepared conversion map to convert data about the charging efficiency of power storage device B that is acquired from display unit 58 into the time for which vehicle 10 can travel and the distance for which the vehicle can travel as shown in Fig. 14. Data transmission unit 60 then transmits to vehicle 10 the data concerning the time and the distance for which vehicle 10 can travel, and vehicle 10 indicates to a user the time and the distance for which the vehicle can travel.

According to the fourth modification of the first embodiment as seen from above, the result of assessment of the degradation state of power storage device B is transmitted from charge station 30 to vehicle 10, and vehicle 10 indicates the result of assessment. Thus, the forth modification can make the user of vehicle 10 aware more strongly of the degradation state of power storage device B.

### [Second Embodiment]

According to a second embodiment, a user can select a charge mode when power storage device B is charged from charge station 30, based on the result of assessment of the degradation indicated to the user. Specifically, the user can select a quick charge mode in which power storage device B is charged at a maximum charge rate, or a low-rate charge mode in which power storage device B is charged at a low charge rate with which progression of degradation of power storage device B can be suppressed.

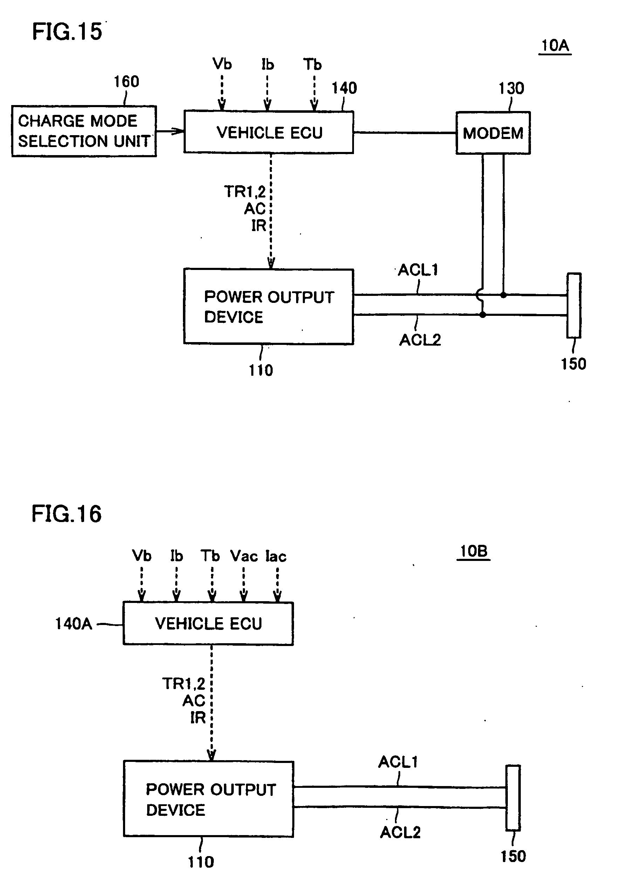

Fig. 15 is a schematic configuration diagram of a vehicle 10A according to the second embodiment. Referring to Fig. 15, vehicle 10A includes a charge mode selection unit 160 in addition to the components of vehicle 10 in the first embodiment shown in Fig. 5. Charge mode selection unit 160 is an input device for allowing a user to select the maximum charge mode or low-rate charge mode when power storage device B is charged from charge station 30.

When charge mode selection unit 160 selects the maximum charge mode, vehicle ECU 140 sets current command IR to a maximum charge rate (2 Ah for example). Accordingly, power output device 110 charges at the maximum charge rate power storage device B (not shown) from charge station 30 (not shown) connected to connector 150.

In contrast, when charge mode selection unit 160 selects the low-rate charge mode, vehicle ECU 140 sets current command IR to a low charge rate (a charge rate lower than 1 Ah for example). Accordingly, power output device 110 charges at the low charge rate power storage device B from charge station 30.

According to the second embodiment as seen from above, the charge mode can be selected according to the determination of the user based on the result of assessment of the degradation state of power storage device B, and thus convenience is improved.

### [Third Embodiment]

According to the first embodiment and its modifications as well as the second embodiment, the degradation state of power storage device B is assessed at charge station 30. According to a third embodiment, the assessment is carried out all on the vehicle side.

Fig. 16 is a schematic configuration diagram of a vehicle in the third embodiment. Referring to Fig. 16, as compared with the components of vehicle 10 in the first embodiment shown in Fig. 5, vehicle 10B does not include modem 130 and includes a vehicle ECU 140A instead of vehicle ECU 140.

Vehicle ECU 140A collects data about voltage Vb, charging current Ib and temperature Tb of power storage device B and collects data about voltage Vac between electric power lines ACL1, ACL2 and current Iac flowing through electric power lines ACL1, ACL2, when power storage device B in power output device 110 is charged from charge station 30 connected to connector 150. Vehicle ECU 140A uses the collected data to assess the degradation state of power storage device B and indicates the result of assessment to a user.

Here, other functions of vehicle ECU 140A are identical to those of vehicle ECU 140 in the first embodiment shown in Fig. 5. Further, other components of vehicle 10B are identical to those of vehicle 10.

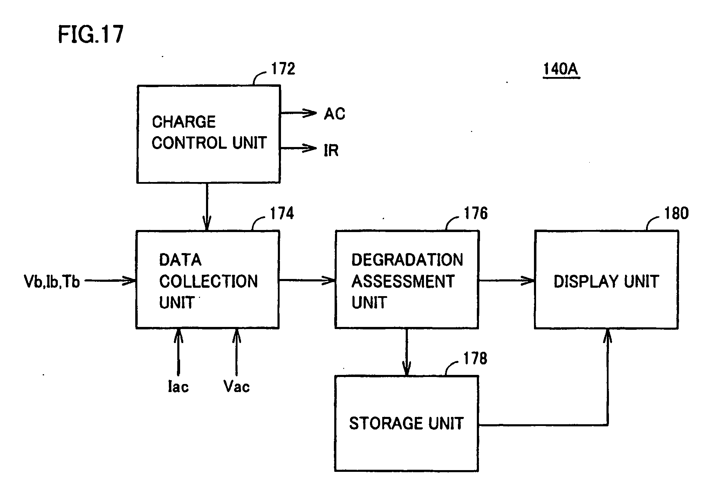

Fig. 17 is a functional block diagram of vehicle ECU 140A shown in Fig. 16. Fig. 17 shows only the functions relevant to the assessment of degradation of power storage device B. Referring to Fig. 17, vehicle ECU 140A includes a charge control unit 172, a data collection unit 174, a degradation assessment unit 176, a storage unit 178, and a display unit 180.

Charge control unit 172 determines whether or not power storage device B is charged from charge station 30 and, when the charging is performed, the charge control unit activates signal AC that is output to power output device 110 and outputs current command IR to power output device 110. When power storage device B is charged from charge station 30, charge control unit 172 gives an instruction to data collection unit 174 to collect data.

When data collection unit 174 receives the instruction to collect data from charge control unit 172, data collection unit 174 collects various data from power output device 110. Specifically, data collection unit 174 collects data about voltage Vb, charging current Ib and temperature Tb of power storage device B as well as voltage Vac and current Iac.

When the data collection by data collection unit 174 is completed, degradation assessment unit 176 uses the collected data to calculate degradation data with which the degradation state of power storage device B can be assessed. Specifically, degradation assessment unit 176 uses the data collected by data collection unit 174 to calculate the charging efficiency. Then, degradation assessment unit 176 outputs the degradation data to storage unit 178.

Storage unit 178 is configured with a nonvolatile memory and, each time vehicle 10B is charged from charge station 30, the storage unit stores the degradation data received from degradation assessment unit 176 in the state where the degradation data is associated with the day and time when the data is collected. Further, storage unit 178 stores assessment data used for assessing the degradation state of power storage device B. Here, the assessment data may be stored in storage unit 178 in advance or acquired from an external server.

Display unit 180 reads from storage unit 178 the degradation data and the assessment data for power storage device B, and indicates the read data to a user. Further, based on the degradation data concerning the latest charging and the past charging, display unit 180 also predicts future progression of degradation and indicates the result of prediction.

According to the third embodiment as seen from above, the degradation state of power storage device B mounted on vehicle 10B can be surely assessed similarly to the first embodiment. Further, the degradation state of power storage device B can be accurately assessed.

Further, in the third embodiment, the degradation state of power storage device B is assessed on the vehicle side and therefore, a special device outside vehicle 10B is unnecessary. Namely, it is unnecessary to provide a degradation assessment device in the charge station.

Further, the above-described third embodiment may allow the vehicle to implement those functions similar to the first to fourth modification of the first embodiment while the functions are adapted to the first embodiment, as well as the functions of the second embodiment. Specifically, a first modification of the third embodiment may use the temperature of power storage device B in the full-charge state instead of the charging efficiency to assess the degradation state of power storage device B, while a detailed description thereof is not given here because the description will be the same as the description above.

Further, a second modification of the third embodiment may increase the charge rate to a constant value higher than a specified value while data is collected, and assess the degradation state of power storage device B, based on the rate of increase of voltage Vb of power storage device B. Further, a third modification of the third embodiment may collect data when the environment while charging is performed satisfies a specified condition, and assess the degradation state of power storage device B based on the collected data. Furthermore, a charge mode selection unit as described in connection with the second embodiment may be provided to allow a user to select the quick charge mode or low-rate charge mode.

### [Fourth Embodiment]

According to a fourth embodiment, a user can select a normal charge mode in which power storage device B is charged from charge station 30 at a normal charge rate, and a quick charge mode in which the power storage device is charged at a charge rate higher than the normal charge rate. According to the selected charge mode, a transition of the degradation state of power storage device B is indicated to a user.

The entire configuration of a degradation assessment system in the fourth embodiment is identical to that of degradation assessment system 100 shown in Fig. 1.

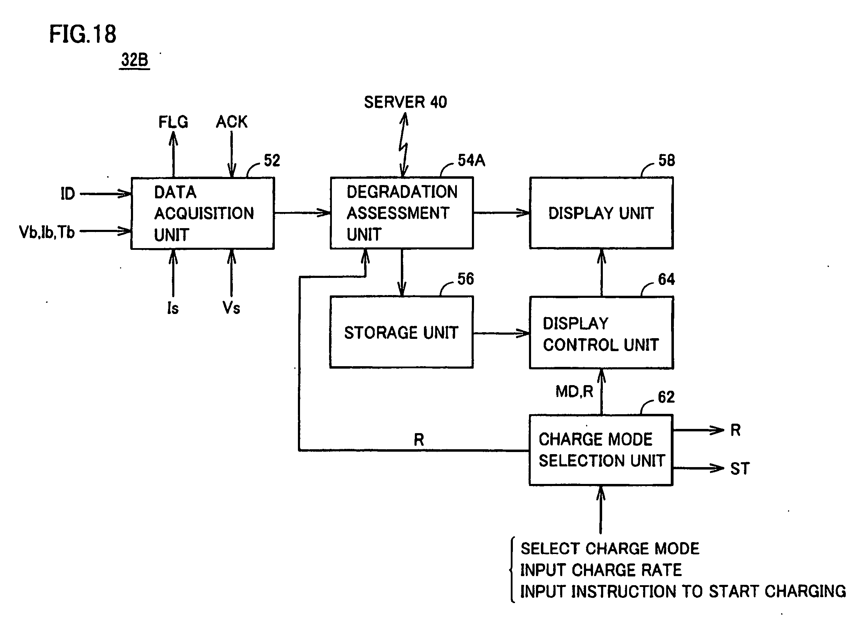

Fig. 18 is a functional block diagram of a degradation assessment device in the fourth embodiment. Referring to Fig. 18, degradation assessment device 32B differs from the configuration of degradation assessment device 32 in the first embodiment shown in Fig. 2 in that the former device further includes a charge mode selection unit 62 and a display control unit 64 and includes a degradation assessment unit 54A instead of degradation assessment unit 54.

Charge mode selection unit 62 is an input unit for allowing a user to select a charge mode, set a charge rate and give an instruction to start charging, when power storage device B is charged from charge station 30. Specifically, the user can select the normal charge mode in which power storage device B is charged from charge station 30 at a normal charge rate, and a quick charge mode in which the power storage device is charged at a charge rate higher than the normal charge rate for the purpose of shortening the time for charging. Further, when the user selects the quick charge mode, the user can set a charge rate (amount of the charging current per unit time for example). Further, the user can give an instruction to start charging after connecting the connector of vehicle 10 to charge station 30.

Charge mode selection unit 62 then transmits to vehicle 10 via connection cable 20 (not shown) signal R for specifying a charge rate when power storage device B is charged from charge station 30, based on the selected charge mode and the set charge rate. Specifically, when the normal charge mode is selected, charge mode selection unit 62 indicates to vehicle 10 a normal charge rate set in advance (predetermined value equal to or lower than 1 Ah for example). When the quick charge mode is selected, charge mode selection unit 62 indicates to vehicle 10 the charge rate set by the user. In the case where the user does not specifically set the charge rate, charge mode selection unit 62 indicates to vehicle 10 a quick charge rate set in advance (maximum charge rate allowable by power storage device B for example).

When the user gives an instruction to start charging, charge mode selection unit 62 transmits signal ST for giving an instruction to perform charging to vehicle 10 via connection cable 20. Further, charge mode selection unit 62 outputs signal R to display control unit 64 and degradation assessment unit 54A and outputs signal MD indicating the selected charge mode to display control unit 64.

Display control unit 64 controls the contents of the indication of display unit 58. Specifically, display unit 58 indicates a transition of the degradation state of power storage device B, and display control unit 64 reads data associated with vehicle 10 from storage unit 56 based on identification code ID of vehicle 10, and indicates the data on display unit 58. When signal MD indicates the normal charge mode, display control unit 64 reads from storage unit 56 the data concerning vehicle 10 charged in the normal charge mode in the past and, based on the read data, predicts a transition of the degradation state regarding the vehicle charged in the normal charge mode in the future. Display control unit 64 then indicates on display unit 58 the predicted transition of the degradation state together with the past transition of the degradation state that is read from storage unit 56.

Further, when signal MD indicates the quick charge mode, display control unit 64 reads from storage unit 56 the data concerning charging performed in the past at the charge rate represented by signal R and, based on the read data, predicts a transition of the degradation state regarding charging performed in the future in the quick charge mode. Display control unit 64 then indicates on display unit 58 the predicted transition of the degradation state together with the past transition of the degradation state.

Degradation assessment unit 54A uses the data acquired by data acquisition unit 52 to calculate degradation data with which the degradation state of power storage device B of vehicle 10 can be assessed. Degradation assessment unit 54A then outputs to storage unit 56 the calculated degradation data in a manner in which the degradation data is associated with the charge rate at this time that is represented by signal R. Here, other functions of degradation assessment unit 54A are identical to those of degradation assessment unit 54 shown in Fig. 2.

Vehicle ECU 140 (Fig. 5) of vehicle 10 that receives signals R, ST generates current command IR based on signal R and activates signal AC based on signal ST. Thus, power storage device B is charged from charge station 30 at the charge rate represented by signal R

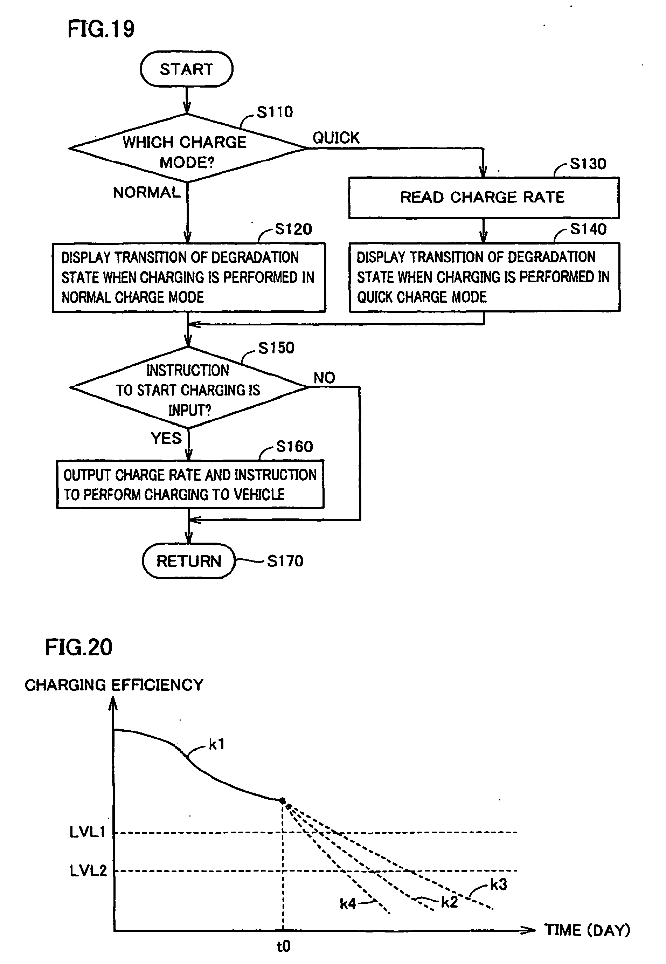

Fig. 19 is a flowchart illustrating a control structure of degradation assessment device 32B in the fourth embodiment. Fig. 19 shows the control structure related to indication of the degradation state that is included in the control performed by degradation assessment device 32B. A control structure related to the data collection and the degradation assessment is identical to the control structure illustrated by the flowchart shown in Fig. 4. The process of the flowchart is also called from a main routine and executed at regular time intervals or each time when a predetermined condition is satisfied.

Referring to Fig. 19, degradation assessment device 32B determines whether a user selects the normal charge mode or the quick charge mode (step S110). When it is determined that the normal charge mode is selected ("normal" in step S 110), degradation assessment device 32B indicates on the display unit a transition of the degradation state in the case where charging is performed in the normal charge mode (step S120). Specifically, degradation assessment device 32B reads the data associated with vehicle 10 from the storage unit and indicates the data, and predicts a transition of the degradation state in the case where charging is performed in the future in the normal charge mode and indicates the predicted transition.

In contrast, when it is determined in step S 110 that the quick charge mode is selected ("quick" in step S 110), degradation assessment device 32B reads the charge rate that is set by the user (step S130). In the case where the user does not set the charge rate, degradation assessment device 32B sets a quick charge rate that is set in advance. Degradation assessment device 32B then indicates on the display unit a transition of the degradation state in the case where charging is performed in the quick charge mode (step S 140). Specifically, degradation assessment device 32B reads from the storage unit the data associated with vehicle 10 and indicates the data, and predicts a transition of the degradation state in the case where charging is performed in the future in the quick charge mode, and then indicates the predicted transition.

When the degradation state of power storage device B is indicated in step S120 or S 140, degradation assessment device 32B determines whether or not the user gives an instruction to start charging (step S150). When it is determined that the instruction to start charging is given (YES in step S150), degradation assessment device 32B outputs to vehicle 10 signal R for indicating the charge rate and signal ST for giving an instruction to perform charging (step S160). In contrast, when it is determined in step S150 that the instruction to start charging is not given (NO in step S150), the process of degradation assessment device 32B advances to step S 170 with step S160 skipped.

Fig. 20 is a diagram showing an example of the state of display when charging is performed in the quick charge mode. In Fig. 20, the case is shown where the charging efficiency is indicted as data with which the degradation state of power storage device B can be assessed. Referring to Fig. 20, a solid line k1 shows a transition of the charging efficiency to the present, and a dotted line k2 shows a predicted future transition of the charging efficiency when charging is performed at a charge rate that is set by a user.

As shown in the drawing, a dotted line k3 showing a transition of the charging efficiency when charging is performed at a charge rate lower by a predetermined rate than the charge rate set by the user as well as a dotted line k4 showing a transition of the charging efficiency when charging is performed at a charge rate higher by a predetermine rate than the set charge rate may be additionally displayed.

Here, the state of the display when charging is performed in the normal charge mode is for example the one shown in Fig. 3.

A transition of the degradation state when charging is performed in the normal charge mode and a transition of the degradation state when charging is performed in the quick charge mode may be indicated on the same screen, which is not particularly shown in the drawing. In this case, the line showing the transition of the charging efficiency when charging is performed in the normal charge mode and the line showing the transition of the charging efficiency when charging is performed in the quick charge mode may be differently colored on the display. Further, first level LVL1 indicating that power storage device B degrades to a considerable degree may be displayed for example with yellow, and second level LVL2 representing a level indicating that power storage device B has to be overhauled may be displayed with red so as to strongly attract the user's attention to the degradation state of power storage device B.

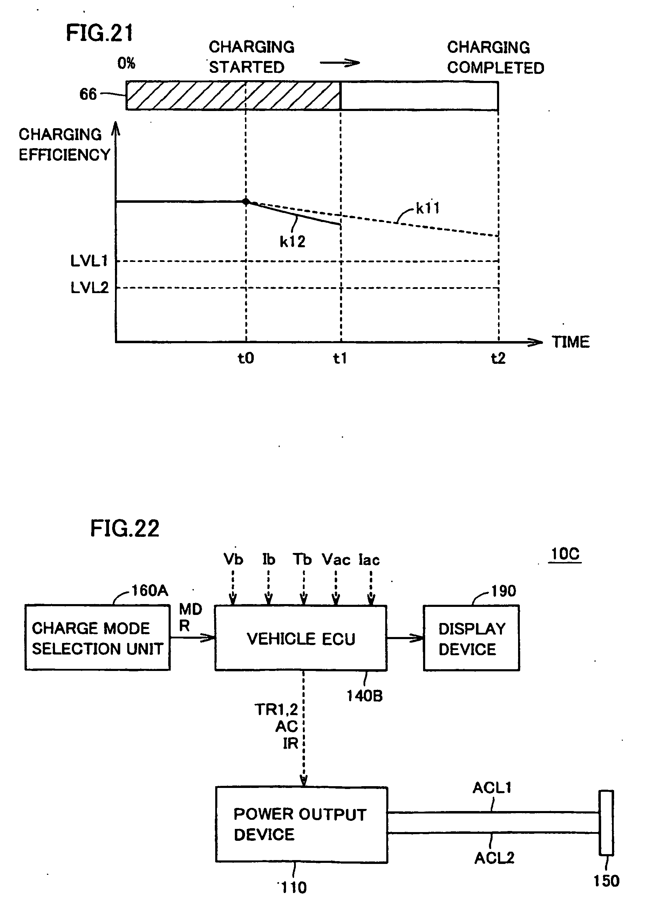

Fig. 21 is a diagram showing an example of the state of display while charging is performed. Referring to Fig. 21, a region 66 indicates the state of charge (SOC) of power storage device B. According to a transition of the SOC while charging is performed as indicated by region 66, a transition of the charging efficiency is indicated. Time t0 represents the time when charging is started, and time t1 represents the present time. Time t2 represents a predicted time when charging is completed. A dotted line k11 indicates a transition of the charging efficiency that is predicted at the time when charging is started, and a solid line k12 indicates an actual transition of the charging efficiency from time t0 to time t1.

In the case where a difference between the actual charging efficiency indicated by solid line k12 and the predicted charging efficiency indicated by dotted line k11 exceeds a predetermined value, solid line k12 may be indicated with red or blinked so as to attract the user's attention.

In connection with the description above, the data indicated on display unit 58 may be transmitted to vehicle 10 via connection cable 20 to indicate, on the vehicle side, the transition of the degradation state of power storage device B. Further, the data indicated on display unit 58 may be output to the outside of charge station 30 to indicate the data for example on a personal computer at home.

According to the fourth embodiment as seen from above, a transition of the degradation state of power storage device B when charging is performed in the normal charge mode and a transition of the degradation state when charging is performed in the quick charge mode are indicated on display unit 58. Thus, the fourth embodiment enables a user to determine the charge mode (and the charge rate) when the power storage device is charged from charge station 30, in consideration of the degradation state of power storage device B.

### [Fifth Embodiment]

According to the fourth embodiment, selection of the charge mode and display of the degradation state of power storage device B are performed on charge station 30 side. According to a fifth embodiment, these operations are all performed on the vehicle side.

Fig. 22 is a schematic configuration diagram of a vehicle 10C in the fifth embodiment. Referring to Fig. 22, vehicle 10C further includes a charge mode selection unit 160A and a display device 190 in addition to the components of vehicle 10B in the third embodiment shown in Fig. 16 and includes vehicle ECU 140B instead of vehicle ECU 140A of vehicle 10B.

Charge mode selection unit 160A has a function similar to that of charge mode selection unit 160 shown in Fig. 18. Charge mode selection unit 160A outputs signal MD indicating a selected charge mode as well as signal R for specifying a charge rate to vehicle ECU 140B.

Display device 190 receives display data from vehicle ECU 140B and indicates a transition of the degradation state of power storage device B. Specifically, when the normal charge mode is selected, display device 190 indicates a transition of the degradation state that is predicted when charging is performed in the normal charge mode, together with a transition of the degradation state in the past. The actual state of display when each charge mode is selected is the one as shown in Fig. 3 (normal charge mode) or the one as shown in Fig. 20 (quick charge mode).

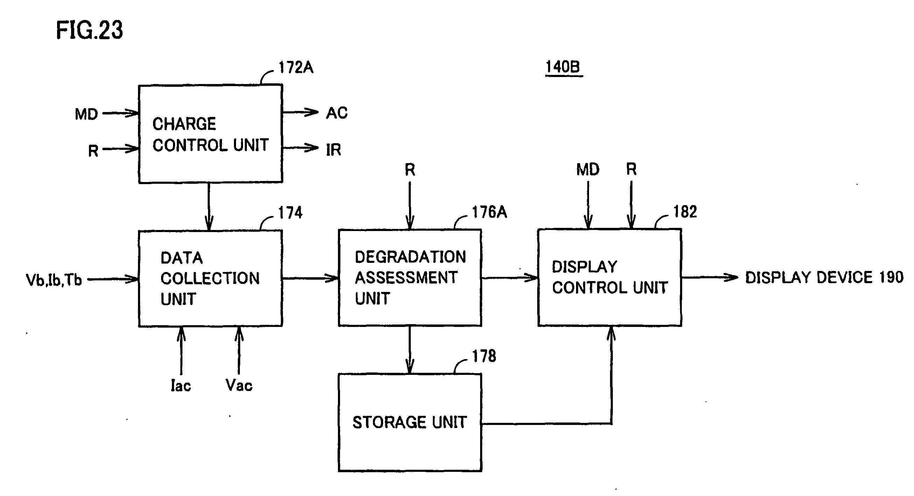

Fig. 23 is a functional block diagram of vehicle ECU 140B shown in Fig. 22. Referring to Fig. 23, vehicle ECU 140B includes a charge control unit 172A, a degradation assessment unit 176A and a display control unit 182 instead of charge control unit 172, degradation assessment unit 176 and display unit 180 included in the components of vehicle 140A in the third embodiment shown in Fig. 17.

Charge control unit 172A sets current command IR that is output to power output device 110, to a preset normal charge rate, when signal MD from charge mode selection unit 160A (not shown) indicates the normal charge mode. In contrast, charge control unit 172A sets current command IR based on the charge rate indicated by signal R from charge mode selection unit 160A when signal MD indicates the quick charge mode. Other functions of charge control unit 172A are similar to those of charge control unit 172 in the third embodiment shown in Fig. 17.

When data collection by data collection unit 174 is completed, degradation assessment unit 176A uses the collected data to calculate the degradation data with which the degradation state of power storage device B can be assessed. Degradation assessment unit 176A associates the calculated degradation data with the charge rate at this time as indicated by signal R and outputs the data to storage unit 178. Other functions of degradation assessment unit 176A are similar to those of degradation assessment unit 176 shown in Fig. 17.

Display control unit 182 has functions similar to those of display control unit 64 shown in Fig. 18. Display control unit 182 outputs the data indicating a transition of the degradation state of power storage device B to display device 190.

In connection with the description above, the data indicated on display device 190 may be transmitted to charge station 30 via connection cable 20 so as to indicate, on the charge station side, the transition of the degradation state of power storage device B. Further, the display data may be further output from charge station 30 to the outside so as so indicate the data for example on a personal computer at home.

According to the fifth embodiment as seen from above, similar effects to those of the fourth embodiment can be achieved. Further, it is unnecessary to provide a special device on the outside of the vehicle, since the degradation state of power storage device B is assessed and displayed on the vehicle side.

In the above-described fourth and fifth embodiments as well, the temperature of power storage device B in the full-charge state may be used instead of the charging efficiency to assess the degradation state of power storage device B and indicate the assessment data on display unit 58 or display device 190, in a manner similar to the first modification of the first embodiment. Further, the data may be collected when the environment while charging is performed satisfies a specified condition, the degradation state of power storage device B may be assessed based on the collected data, and the assessment data may_be indicated on display unit 58 or display device 190, in a manner similar to the third modification of the first embodiment.

In each of the above-described embodiments, power storage device B of vehicles 10, 10A-10C each is charged from charge station 30. The electric power may be supplied in the opposite direction from vehicles 10, 10A-10C each to charge station 30, or electric power may be supplied from vehicles 10, 10A-10C each to an electrical load connected to connector 150. When the electric power is supplied from vehicles 10, 10A-10C each to charge station 30 or the electrical load as well, the environment (such as temperature) of power storage device B is stable as compared with that while vehicles 10, 10A-10C are each traveling and the conditions of powering from power storage device B can be set freely to a certain degree, which is similar to the state when charging is performed. Therefore, when electric power is supplied from vehicles 10, 10A-10C each to charge station 30 or the electrical load, the data about power storage device B may be collected and, based on the collected data, degradation of power storage device B may be assessed.

Referring again to Fig. 7, the zero-phase equivalent circuit can also be regarded as a single-phase PWM inverter using a DC voltage supplied from positive line PL2 to generate a single-phase AC voltage at neutral points N1, N2. Accordingly, the zero voltage vector may be varied for inverters 320, 330 each, and inverters 320, 330 may be switching-controlled so that the inverters each operate as each phase arm of the single-phase PWM inverter, so as to allow the DC power from positive line PL2 into AC power to output the AC power to electric power lines ACL1, ACL2.

In the above-described embodiments each, vehicles 10, 10A-10C each include motor generators MG1, MG2 and electric power is input/output via neutral points N1, N2 of motor generators MG1, MG2 when the electric power is supplied and received from and to charge station 30. Alternatively, a dedicated inverter may be provided separately for supplying and receiving electric power between power storage device B and connector 150 connected to charge station 30.

Further, according to the description above, vehicles 10, 10A-10C are each a hybrid vehicle mounted with an engine and motor generators serving as power sources. The vehicle, however, may be mounted with a power storage device and configured to be able to supply and receive electric power between the power storage device and an electric power supply or electrical load outside the vehicle.

In connection with the description above, the process performed by degradation assessment devices 32, 32A, 32B and vehicle ECUs 140, 140A, 140B each is actually performed by a CPU (Central Processing Unit), and the CPU reads from a ROM (Read Only Memory) a program including each step of the above-described flowcharts, and executes the program to perform the process following the flowchart. Therefore, the ROM corresponds to a computer (CPU)-readable recording medium on which a program including each step of the above-described flowcharts is recorded.

In connection with the description above, degradation assessment devices 32, 32A, 32B and vehicle ECUs 140A, 140B each correspond to "degradation assessment device" of the present invention, and motor generators MG1, MG2, inverters 220, 230, and voltage step-up converter 210 are components of "electric power conversion device" of the present invention. Further, electric power lines ACL1, ACL2 and connector 150 are each a component of "connection device" of the present invention, and MG-ECU 240 corresponds to "control device" of the present invention.

It should be construed that embodiments disclosed herein are by way of illustration in all respects, not by way of limitation. It is intended that the scope of the present invention is defined by claims, not by the above description of the embodiments.

## Claims

1. A degradation assessment system comprising:
a vehicle (10) comprising a traveling-purpose motor (MG2) generating a drive power of the vehicle and a power storage device (B) as a power supply for the traveling-purpose motor (MG2), and
a system power supply outside the vehicle;
said degradation assessment system configured to be able to charge said power storage device from the system power supply; and a degradation assessment device (32, 32A, 32B) by **characterized by**
the degradation assessment device being configured to assess a degradation state of said power storage device on the basis of a charging efficiency calculated with data (V_{b}, I_{b}, T_{b}) collected when said power storage device is charged from said system power supply, wherein the charging efficiency refers to the ratio of the amount of electrically power actually stored in the power storage device of the vehicle and the amount of power supplied from the system power supply to the power storage device of the vehicle.

2. The degradation assessment system according to claim 1, further comprising:
a charge mode selection unit (160) capable of selecting one of a normal charge mode in which said power storage device is charged from said system power supply at a first charge rate, and a quick charge mode in which said power storage device is charged from said system power supply at a second charge rate higher than said first charge rate; and
a display unit (58) capable of displaying a degradation state of said power storage device in a case where charging is performed in said normal charge mode, and a degradation state of said power storage device in a case where charging is performed in said quick charge mode.

3. The degradation assessment system according to claim 1, wherein
said vehicle includes:
an electric power conversion device (MG1, MG2, 220, 230, 210) configured to be able to convert electric power between said power storage device and said system power supply;
a connection device (ACL1, ACL2, 150) configured to be able to electrically connect said electric power conversion device to said system power supply; and
a control device (240) controlling said electric power conversion device, and
said control device controls said electric power conversion device under a constant condition at least when said data is collected.

4. The degradation assessment system according to claim 3, wherein
when said data (V_{b}, I_{b}, T_{b}) is collected, said control device controls said electric power conversion device such that a charging electric power (Iₛ, Vₛ) from said system power supply to said power storage device is larger than a specified value.

5. The degradation assessment system according to claim 1, wherein
said degradation assessment device assesses the degradation state of said power storage device when the temperature surrounding said vehicle satisfies a predetermined condition.

6. The degradation assessment system according to claim 2, wherein
said display unit displays a state of charge of said power storage device and displays a transition of the degradation state of said power storage device in conjunction with a transition of said state of charge, while said power storage device is charged from said system power supply.

7. A degradation assessment method for assessing the degradation of a power storage device (B) mounted on a vehicle(10) as a power supply for a traveling-purpose motor (MG2) generating a drive power of the vehicle,
said vehicle being configured to be able to charge said power storage device from a system power supply outside the vehicle,
said degradation assessment method comprising:
a first step of collecting data (V_{b}, I_{b}, T_{b}) for calculating a charging efficiency and assessing a degradation state of said power storage device when said power storage device is charged from said system power supply, and
wherein the charging efficiency level refers to the ratio of the amount of electrically power actually stored in the power storage device of the vehicle and the amount of power supplied from the system power supply to the power storage device of the vehicle; and
a second step of assessing the degradation state of said power storage device on the basis of the charging efficiency using the collected data.

8. The degradation assessment method according to claim 7, further comprising:
a third step of selecting one of a normal charge mode in which said power storage device is charged from said system power supply at a first charge rate, and a quick charge mode in which said power storage device is charged from said system power supply at a second charge rate higher than said first charge rate; and
a fourth step of displaying at least one of a degradation state of said power storage device in a case where charging is performed in said normal charge mode, and a degradation state of said power storage device in a case where charging is performed in said quick charge mode.

9. The degradation assessment method according to claim 7, wherein
said vehicle includes:
an electric power conversion device (MG1, MG2, 220, 230, 210) configured to be able to convert electric power between said power storage device and said system power supply; and
a connection device (ACL1, ACL2, 150) configured to be able to electrically connect said electric power conversion device to said system power supply, and
said degradation assessment method further comprises a fifth step of controlling said electric power conversion device under a constant condition at least when said data is collected.

10. The degradation assessment method according to claim 9, wherein
when said data is collected, said electric power conversion device is controlled in said fifth step such that a charging electric power from said system power supply to said power storage device is larger than a specified value.

11. The degradation assessment method according to claim 7, further comprising a sixth step of determining whether or not the temperature of said vehicle or of the surrounding of said vehicle satisfies a predetermined condition, wherein
when it is determined that said temperature satisfies said predetermined condition, the degradation state of said power storage device is assessed in said second step.

12. The degradation assessment method according to claim 8, wherein
in said fourth step, a state of charge of said power storage device is displayed and a transition of the degradation state of said power storage device is displayed in conjunction with a transition of said state of charge, while said power storage device is charged from said system power supply.

13. The degradation assessment system according to claim 1, wherein the degradation assessment device (32, 32A, 32B) comprises for each type of vehicle a first and a second charging efficiency level as assessment data for assessing the degradation state of said power storage device, wherein the first charging efficiency level indicates that the power storage device (B) degrades to a considerable degree and the second charging efficiency level indicates that the power storage device has to be overhauled.

14. The degradation assessment method according to claim 7, further comprising the step of
obtaining from a server assessment data for the respective type of vehicle, wherein the assessment data comprises a first and a second charging efficiency level as assessment data for assessing the degradation state of said power storage device and
wherein the first charging efficiency level indicates that the power storage device (B) degrades to a considerable degree and the second charging efficiency level indicates that the power storage device has to be overhauled.

15. The degradation assessment system according to claim 1, wherein said degradation assessment device (32, 32A, 32B) is configured to display to a user the degradation of said charging efficiency with time, together with a first charging efficiency level indicating that said power storage device degrades to a considerable degree and a second charging efficiency level indicating that said power storage device has to be overhauled, and
wherein said degradation assessment device is configured to display said first charging efficiency and said second charging efficiency in respective colors different from each other.

16. The degradation assessment method according to claim 7, further comprising the steps of
displaying to a user the degradation of said charging efficiency with time, together with a first charging efficiency level indicating that said power storage device degrades to a considerable degree and a second charging efficiency level indicating that said power storage device has to be overhauled, and
displaying said first charging efficiency and said second charging efficiency in respective colors different from each other.

## Patentansprüche

1. Degradationsbeurteilungssystem, aufweisend
ein Fahrzeug (10), das einen für Reisezwecke ausgelegten Motor (MG2), der eine Antriebsleistung des Fahrzeugs erzeugt, und eine Leistungsspeichervorrichtung (B) als eine Leistungsversorgung für den für Reisezwecke ausgelegten Motor (MG2) aufweist, und
eine Systemleistungsversorgung außerhalb des Fahrzeugs;
wobei das Degradationsbeurteilungssystem so konfiguriert ist, dass es die Leistungsspeichervorrichtung durch die Systemleistungsversorgung aufladen kann; und
eine Degradationsbeurteilungsvorrichtung (32, 32A, 32B), **dadurch gekennzeichnet, dass** die Degradationsbeurteilungsvorrichtung so konfiguriert ist, dass sie einen Degradationszustand der Leistungsspeichervorrichtung auf Basis einer Ladeeffizienz beurteilt, die anhand von Daten (Vb, Ib, Tb) berechnet wird, die erfasst werden, wenn die Leistungsspeichervorrichtung durch die Systemsleistungsversorgung aufgeladen wird, wobei sich die Ladeeffizienz auf das Verhältnis der Menge der elektrischen Leistung, die tatsächlich in der Leistungsspeichervorrichtung des Fahrzeugs gespeichert ist, und die Menge der Leistung bezieht, die der Leistungsspeichervorrichtung des Fahrzeugs von der Systemleistungsversorgung zugeführt wird.

2. Degradationsbeurteilungssystem nach Anspruch 1, ferner aufweisend:
eine Lademodus-Auswähleinheit (160), die entweder einen Normallademodus, in dem die Leistungsspeichervorrichtung durch die Systemleistungsversorgung mit einer ersten Laderate aufgeladen wird, oder einen Schnellelademodus auswählt, in dem die Leistungsspeichervorrichtung durch die Systemleistungsversorgung mit einer über der ersten Laderate liegenden zweiten Laderate aufgeladen wird; und
eine Anzeigeeinheit (58), die einen Degradationszustand der Leistungsspeichervorrichtung in einem Fall, in dem der Ladevorgang in dem Normallademodus ausgeführt wird, und einen Degradationszustand der Leistungsspeichervorrichtung in einem Fall anzeigen kann, in dem der Ladevorgang in dem Schnelllademodus ausgeführt wird.

3. Degradationsbeurteilungssystem nach Anspruch 1, wobei das Fahrzeug beinhaltet:
eine elektrische Leistungsumwandlungsvorrichtung (MG1, MG2, 220, 230, 210), die so konfiguriert ist, dass sie die elektrische Leistung zwischen der Leistungsspeichervorrichtung und der Systemleistungsversorgung umwandeln kann;
eine Verbindungsvorrichtung (ACL1, ACL2, 150), die so konfiguriert ist, dass sie die elektrische Leistungsumwandlungsvorrichtung mit der Systemleistungsversorgung elektrisch verbinden kann; und
eine Steuerungsvorrichtung (240), die die elektrische Leistungsumwandlungsvorrichtung steuert, und
die Steuerungsvorrichtung die elektrische Leistungsumwandlungsvorrichtung unter einer konstanten Bedingung zumindest dann steuert, wenn die Daten erfasst werden.

4. Degradationsbeurteilungssystem nach Anspruch 3, wobei
wenn die Daten (Vb, Ib, Tb) erfasst werden, die Steuerungsvorrichtung die elektrische Leistungsumwandlungsvorrichtung derart steuert, dass eine elektrische Ladeleistung (Is, Vs) von der Systemleistungsversorgung zu der Leistungsspeichervorrichtung einem vorgegebenen Wert überschreitet.

5. Degradationsbeurteilungssystem nach Anspruch 1, wobei
die Degradationsbeurteilungsvorrichtung den Degradationszustand der Leistungsspeichervorrichtung beurteilt, wenn die Temperatur in der Umgebung des Fahrzeugs eine vorbestimmte Bedingung erfüllt.

6. Degradationsbeurteilungssystem nach Anspruch 2, wobei
die Anzeigeeinheit einen Ladezustand der Leistungsspeichervorrichtung anzeigt und einen Übergang des Degradationszustands der Leistungsspeichervorrichtung in Verbindung mit einem Übergang des Ladezustands anzeigt, während die Leistungsspeichervorrichtung von der Systemleistungsversorgung aufgeladen wird.

7. Degradationsbeurteilungsverfahren zur Beurteilung der Degradation einer an einem Fahrzeug (10) montierten Leistungsspeichervorrichtung (B) als eine Leistungsversorgung für einen für Reisezwecke ausgelegten Motor (MG2), der eine Antriebsleistung des Fahrzeugs erzeugt,
wobei das Fahrzeug so konfiguriert ist, dass die Leistungsspeichervorrichtung anhand einer Systemleistungsversorgung außerhalb des Fahrzeugs aufgeladen werden kann,
wobei das Degradationsbeurteilungsverfahren beinhaltet:
einen ersten Schritt des Erfassens von Daten (Vb, Ib, Tb) zum Berechnen einer Ladeeffizienz und zum Beurteilen eines Degradationszustands der Leistungsspeichervorrichtung, wenn die Leistungsspeichervorrichtung durch die Systemleistungszuführung aufgeladen wird, und
wobei der Ladeeffizienzwert sich auf das Verhältnis der Menge der elektrischen Leistung, die tatsächlich in der Leistungsspeichervorrichtung des Fahrzeugs gespeichert ist, und auf die Menge der von der Systemleistungsversorgung des Fahrzeugs zugeführten Leistung bezieht; und
einen zweiten Schritt des Beurteilens des Degradationszustands der Leistungsspeichervorrichtung auf Basis der Ladeeffizienz unter Verwendung der erfassten Daten.

8. Degradationsbeurteilungsverfahren nach Anspruch 7, ferner beinhaltend:
einen dritten Schritt des Auswählens von entweder einem Normallademodus, in dem die Leistungsspeichervorrichtung durch die Systemleistungsversorgung mit einer ersten Laderate aufgeladen wird, oder einem Schnellelademodus, in dem die Leistungsspeichervorrichtung durch die Systemleistungsversorgung mit einer über der ersten Laderate liegenden zweiten Laderate aufgeladen wird; und
einen vierten Schritt des Anzeigens von zumindest entweder einem Degradationszustand der Leistungsspeichervorrichtung in einem Fall, in dem der Ladevorgang in dem Normallademodus ausgeführt wird, oder einem Degradationszustand der Leistungsspeichervorrichtung in einem Fall, in dem der Ladevorgang in dem Schnelllademodus ausgeführt wird.

9. Degradationsbeurteilungsverfahren nach Anspruch 7, wobei das Fahrzeug beinhaltet:
eine elektrische Leistungsumwandlungsvorrichtung (MG1, MG2, 220, 230, 210),
die so konfiguriert ist, dass sie die elektrische Leistung zwischen der Leistungsspeichervorrichtung und der Systemleistungsversorgung umwandeln kann;
eine Verbindungsvorrichtung (ACL1, ACL2, 150), die so konfiguriert ist, dass sie die elektrische Leistungsumwandlungsvorrichtung mit der Systemleistungsversorgung verbinden kann, und
wobei das Degradationsbeurteilungsverfahren ferner einen fünften Schritt des Steuerns der elektrischen Leistungsumwandlungsvorrichtung unter einer konstanten Bedingung zumindest dann beinhaltet, wenn die Daten erfasst werden.

10. Degradationsbeurteilungsverfahren nach Anspruch 9, wobei
wenn die Daten erfasst werden, die elektrische Leistungsumwandlungsvorrichtung in dem fünften Schritt derart gesteuert wird, dass eine elektrische Ladeleistung von der Systemleistungsversorgung zu der Leistungsspeichervorrichtung über einem vorgegebenen Wert liegt.

11. Degradationsbeurteilungsverfahren nach Anspruch 7, das ferner beinhaltet:
einen sechsten Schritt des Bestimmens, ob die Temperatur des Fahrzeug oder der Umgebung des Fahrzeugs eine vorbestimmte Bedingung erfüllt oder nicht, wobei wenn bestimmt wird, dass die Temperatur die vorbestimmte Bedingung erfüllt, der Degradationszustand der Leistungsspeichervorrichtung in dem zweiten Schritt beurteilt.

12. Degradationsbeurteilungsverfahren nach Anspruch 8, wobei
in dem vierten Schritt, ein Zustand der Ladung der Leistungsspeichervorrichtung angezeigt wird und ein Übergang des Ladungszustands der Leistungsspeichervorrichtung in Verbindung mit einem Übergang des Zustands der Ladung angezeigt wird, während die Leistungsspeichervorrichtung durch die Systemleistungsversorgung aufgeladen wird.

13. Degradationsbeurteilungssystem nach Anspruch 1, wobei die Degradationsbeurteilungsvorrichtung (32, 32A, 32B) für einen jeden Fahrzeugtyp einen ersten und einen zweiten Ladeeffizienzwert als Beurteilungsdaten zum Beurteilen des Degradationszustands der Leistungsspeichervorrichtung aufweist, wobei der erste Ladeeffizienzwert anzeigt, dass die Leistungsspeichervorrichtung (B) sich in erheblichem Maße verschlechtert hat, und der zweite Ladeeffizienzwert anzeigt, dass die Leistungsspeichervorrichtung gewartet werden muss.

14. Degradationsbeurteilungsverfahren nach Anspruch 7, ferner beinhaltend den Schritt des
Einholens von Beurteilungsdaten für den jeweiligen Fahrzeugtyp von einem Server, wobei die Beurteilungsdaten einen ersten und einen zweiten Ladeeffizienzwert als Beurteilungsdaten zum Beurteilen des Degradationszustands der Leistungsspeichervorrichtung aufweisen, und
wobei der erste Ladeeffizienzwert anzeigt, dass die Leistungsspeichervorrichtung (B) sich in erheblichem Maße verschlechtert hat, und der zweite Ladeeffizienzwert anzeigt, dass die Leistungsspeichervorrichtung gewartet werden muss.

15. Degradationsbeurteilungssystem nach Anspruch 1, wobei die Degradationsbeurteilungsvorrichtung (32, 32A, 32B) so konfiguriert ist, dass sie einem Benutzer die Degradation der Ladeeffizienz im Zeitverlauf, zusammen mit einem ersten Ladeeffizienzwert, der anzeigt, dass die Leistungsspeichervorrichtung sich in erheblichem Maße verschlechtert hat, und einem zweiten Ladeffizienzwert anzeigt, der anzeigt, dass Leistungsspeichervorrichtung gewartet werden muss, und
wobei die Degradationsbeurteilungsvorrichtung so konfiguriert ist, dass sie die erste Ladeeffizienz und die zweite Ladeeffizienz in jeweiligen sich voneinander unterscheidenden Farben anzeigt.

16. Degradationsbeurteilungsverfahren nach Anspruch 7, ferner aufweisend die Schritte:
einem Benutzer Anzeigen der Degradation der Ladeeffizienz im Zeitverlauf, zusammen mit einem ersten Ladeeffizienzwert, der anzeigt, dass die Leistungsspeichervorrichtung sich in erheblichem Maß verschlechtert hat, und einem zweiten Ladeeffizienzwert, der anzeigt, dass die Leistungsspeichervorrichtung gewartet werden muss, und
Anzeigen der ersten Ladeeffizienz und der zweiten Ladeeffizienz in jeweiligen sich voneinander unterscheidenden Farben.

## Revendications

1. Système d'évaluation de dégradation comprenant :
un véhicule (10) comprenant un moteur à but de déplacement (MG2) générant une puissance d'entraînement du véhicule et un dispositif de stockage de puissance (B) en tant qu'alimentation de puissance pour le moteur à but de déplacement (MG2), et
une alimentation de puissance de système à l'extérieur du véhicule ;
ledit système d'évaluation de dégradation étant configuré pour pouvoir charger ledit dispositif de stockage de puissance à partir de l'alimentation de puissance de système ; et un dispositif d'évaluation de dégradation (32, 32A, 32B) étant **caractérisé par** :
le dispositif d'évaluation de dégradation étant configuré pour évaluer un état de dégradation dudit dispositif de stockage de puissance en fonction d'un rendement de charge calculé avec des données (V_{b}, I_{b}, T_{b}) collectées lorsque ledit dispositif de stockage de puissance est chargé à partir de ladite alimentation de puissance de système, dans lequel le rendement de charge fait référence au rapport de la quantité de puissance électrique vraiment stockée dans le dispositif de stockage de puissance du véhicule et de la quantité de puissance fournie par l'alimentation de puissance de système au dispositif de stockage de puissance du véhicule.

2. Système d'évaluation de dégradation selon la revendication 1, comprenant en outre :
une unité de sélection de mode de charge (160) pouvant sélectionner l'un parmi un mode de charge normal dans lequel ledit dispositif de stockage de puissance est chargé à partir de ladite alimentation de puissance de système à un premier taux de charge, et un mode de charge rapide dans lequel ledit dispositif de stockage de puissance est chargé à partir de ladite alimentation de puissance de système à un deuxième taux de charge supérieur audit premier taux de charge ; et
une unité d'affichage (58) pouvant afficher un état de dégradation dudit dispositif de stockage de puissance dans le cas dans lequel la charge est réalisée dans ledit mode de charge normal, et un état de dégradation dudit dispositif de stockage de puissance dans le cas dans lequel la charge est réalisée dans ledit mode de charge rapide.

3. Système d'évaluation de dégradation selon la revendication 1, dans lequel :
ledit véhicule comprend :
un dispositif de conversion de puissance électrique (MG1, MG2, 220, 230, 210) configuré pour pouvoir convertir la puissance électrique entre ledit dispositif de stockage de puissance et ladite alimentation de puissance électrique ;
un dispositif de raccordement (ACL1, ACL2, 150) configuré pour pouvoir raccorder électriquement ledit dispositif de conversion de puissance électrique à ladite alimentation de puissance de système ; et
un dispositif de contrôle (240) contrôlant ledit dispositif de conversion de puissance électrique, et
ledit dispositif de contrôle contrôle ledit dispositif de conversion de puissance électrique dans une condition constante au moins lorsque lesdites données sont collectées.

4. Système d'évaluation de dégradation selon la revendication 3, dans lequel :
lorsque lesdites données (V_{b}, I_{b}, T_{b}) sont collectées, ledit dispositif de contrôle contrôle ledit dispositif de conversion de puissance électrique de sorte qu'une puissance électrique de charge (Iₛ, Vₛ) allant de ladite alimentation de puissance de système audit dispositif de stockage de puissance est supérieure à une valeur spécifiée.

5. Système d'évaluation de dégradation selon la revendication 1, dans lequel :
ledit dispositif d'évaluation de dégradation évalue l'état de dégradation dudit système de stockage de puissance lorsque la température entourant ledit véhicule satisfait une condition prédéterminée.

6. Système d'évaluation de dégradation selon la revendication 2, dans lequel :
ladite unité d'affichage affiche un état de charge dudit dispositif de stockage de puissance et affiche une transition de l'état de dégradation dudit dispositif de stockage de puissance conjointement avec une transition dudit état de charge, alors que ledit dispositif de stockage de puissance est chargé à partir de l'alimentation de puissance de système.

7. Procédé d'évaluation de dégradation pour évaluer la dégradation d'un dispositif de stockage de puissance (B) monté sur un véhicule (10) en tant qu'alimentation de puissance pour un moteur à but de déplacement (MG2) générant une puissance d'entraînement du véhicule,
ledit véhicule étant configuré pour pouvoir charger ledit dispositif de stockage de puissance à partir d'une alimentation de puissance de système à l'extérieur du véhicule,
ledit procédé d'évaluation de dégradation comprenant :
une première étape consistant à collecter des données (V_{b}, I_{b}, T_{b}) pour calculer un rendement de charge et évaluer un état de dégradation dudit dispositif de stockage de puissance lorsque ledit dispositif de stockage de puissance est chargé à partir de ladite alimentation de puissance de système, et
dans lequel le niveau de rendement de charge concerne le rapport de la quantité de puissance électrique vraiment stockée dans le dispositif de stockage de puissance du véhicule et de la quantité de puissance fournie de l'alimentation de puissance de système au dispositif de stockage de puissance du véhicule ; et
une deuxième étape consistant à évaluer l'état de dégradation dudit dispositif de stockage de puissance en fonction du rendement de charge, à l'aide de données collectées.

8. Procédé d'évaluation de dégradation selon la revendication 7, comprenant en outre :
une troisième étape consistant à sélectionner l'un parmi un mode de charge normal dans lequel le dispositif de stockage de puissance est chargé à partir de ladite alimentation de puissance de système à un premier taux de charge, et un mode de charge rapide dans lequel ledit dispositif de stockage de puissance est chargé à partir de ladite alimentation de puissance de système à un deuxième taux de charge supérieur audit premier taux de charge ; et
une quatrième étape consistant à afficher au moins l'un parmi un état de dégradation dudit dispositif de stockage de puissance dans le cas dans lequel la charge est réalisée dans ledit mode de charge normal, et un état de dégradation dudit dispositif de stockage de puissance dans le cas dans lequel la charge est réalisée dans ledit mode de charge rapide.

9. Procédé d'évaluation de dégradation selon la revendication 7, dans lequel ledit véhicule comprend :
un dispositif de conversion de puissance électrique (MG1, MG2, 220, 230, 210) configuré pour pouvoir convertir la puissance électrique entre ledit dispositif de stockage de puissance et ladite alimentation de puissance de système ; et
un dispositif de raccordement (ACL1, ACL2, 150) configuré pour pouvoir raccorder électriquement ledit dispositif de conversion de puissance électrique à ladite alimentation de puissance de système, et
ledit procédé d'évaluation de dégradation comprend en outre une cinquième étape consistant à contrôler ledit dispositif de conversion de puissance électrique dans une condition constante, au moins lorsque lesdites données sont collectées.

10. Procédé d'évaluation de dégradation selon la revendication 9, dans lequel :
lorsque lesdites données sont collectées, ledit dispositif de conversion de puissance électrique est contrôlé dans ladite cinquième étape de sorte qu'une puissance électrique de charge, de ladite alimentation de puissance de système audit dispositif de stockage de puissance, est supérieure à une valeur spécifiée.

11. Procédé d'évaluation de dégradation selon la revendication 7, comprenant en outre une sixième étape consistant à déterminer si la température dudit véhicule ou de l'environnement dudit véhicule satisfait une condition prédéterminée ou pas, dans lequel :
lorsque l'on considère que ladite température satisfait ladite condition prédéterminée, l'état de dégradation dudit dispositif de stockage de puissance est évalué à ladite deuxième étape.

12. Procédé d'évaluation de dégradation selon la revendication 8, dans lequel :
à ladite quatrième étape, un état de charge dudit dispositif de stockage de puissance est affiché et une transition de l'état de dégradation dudit dispositif de stockage de puissance est affichée conjointement avec une transition dudit état de charge, alors que ledit dispositif de stockage de puissance est chargé à partir de ladite alimentation de puissance de système.

13. Système d'évaluation de dégradation selon la revendication 1, dans lequel le dispositif d'évaluation de dégradation (32, 32A, 32B) comprend pour chaque type de véhicule un premier et deuxième niveau de rendement de charge en tant que données d'évaluation pour évaluer l'état de dégradation dudit dispositif de stockage de puissance, dans lequel ledit premier niveau de rendement de charge indique que le dispositif de stockage de puissance (B) se dégrade jusqu'à un degré considérable et le deuxième niveau de rendement de charge indique que le dispositif de stockage de puissance doit être remis en état.

14. Procédé d'évaluation de dégradation selon la revendication 7, comprenant en outre l'étape consistant à :
obtenir, à partir d'un serveur, des données d'évaluation pour le type respectif de véhicule, dans lequel les données d'évaluation comprennent un premier et un deuxième niveau de rendement de charge en tant que données d'évaluation pour évaluer l'état de dégradation dudit dispositif de stockage de puissance, et
dans lequel le premier niveau de rendement de charge indique que le dispositif de stockage de puissance (B) se dégrade jusqu'à un degré considérable et le deuxième niveau de rendement de charge indique que le dispositif de stockage de puissance doit être remis en état.

15. Système d'évaluation de dégradation selon la revendication 1, dans lequel ledit dispositif d'évaluation de dégradation (32, 32A, 32B) est configuré pour afficher à un utilisateur, la dégradation dudit rendement de charge avec le temps, conjointement avec un premier niveau de rendement de charge indiquant que ledit dispositif de stockage de puissance se dégrade jusqu'à un degré considérable et ledit deuxième niveau de rendement de charge indiquant que ledit dispositif de stockage de puissance doit être remis en état, et
dans lequel ledit dispositif d'évaluation de dégradation est configuré pour afficher ledit premier rendement de charge et ledit deuxième rendement de charge avec des couleurs respectives différentes l'une de l'autre.

16. Procédé d'évaluation de dégradation selon la revendication 7, comprenant en outre les étapes consistant à :
afficher, à un utilisateur, la dégradation dudit rendement de charge avec le temps, conjointement avec un premier niveau de rendement de charge indiquant que ledit dispositif de stockage de puissance se dégrade jusqu'à un degré considérable et le deuxième niveau de rendement de charge indiquant que ledit dispositif de stockage de puissance doit être remis en état, et
afficher ledit premier rendement de charge et ledit deuxième rendement de charge avec des couleurs respectives différentes l'une de l'autre.
